# EUROPEAN PATENT SPECIFICATION

(11) **EP 4 583 497 B1**
(45) Date of publication and mention of the grant of the patent: **30.09.2026**
(21) Application number: 23868434.4
(22) Date of filing: 31.08.2023
(51) Int. Cl.: H04M 1/02, G06F 1/16, H10K 77/10, H10K 59/126, H10K 59/35, G09F 9/30, H10K 102/00

(54) **DISPLAY FOR PROVIDING UNIFORM DISPLAY REGION AND ELECTRONIC DEVICE COMPRISING SAME**
ANZEIGE ZUR BEREITSTELLUNG EINES GLEICHFÖRMIGEN ANZEIGEBEREICHS UND ELEKTRONISCHE VORRICHTUNG DAMIT
AFFICHAGE DE FOURNITURE DE RÉGION D'AFFICHAGE UNIFORME ET DISPOSITIF ÉLECTRONIQUE LE COMPRENANT

(30) Priority: 20.09.2022 KR 20220118956; 04.11.2022 KR 20220146542; 30.11.2022 KR 20220164298
(43) Date of publication of application: 09.07.2025
(73) Proprietor: Samsung Electronics Co., Ltd., Suwon-si, Gyeonggi-do 16677 (KR)
(72) Inventor: CHOI, Seungyeop, Suwon-si Gyeonggi-do 16677 (KR); KIM, Kwangtai, Suwon-si Gyeonggi-do 16677 (KR); KIM, Suyeon, Suwon-si Gyeonggi-do 16677 (KR); YANG, Byungduk, Suwon-si Gyeonggi-do 16677 (KR); CHOI, Sungdae, Suwon-si Gyeonggi-do 16677 (KR)
(74) Representative: HGF
(86) International application number: PCT/KR2023/013037
(87) International publication number: WO 2024/063379

(56) References cited:
- CN-A- 111 048 563
- JP-A- 2009 517 710
- KR-A- 20200 144 903
- KR-A- 20210 058 433
- KR-A- 20210 147 121
- KR-A- 20220 006 667
- US-A1- 2021 202 633
- US-A1- 2022 045 137

## Description

### [Technical Field]

The present disclosure relates to a display for providing a uniform display region and an electronic device comprising the same.

### [Background Art]

There is an increasing need for an electronic device in which a size of a display for displaying content may be changed so that a user may be provided with various contents through the electronic device. For example, the electronic device may provide a structure in which the size of the display for displaying the content may be changed, by including a foldable flexible display. US 2022/045137 A1 describes a flexible display apparatus that maintains high external visibility while improving mechanical flexibility by combining inorganic layers with recesses and organic materials filled into those recesses. Pixel electrodes are arranged in varying numbers and inclinations across different areas of the inorganic layer to optimize light emission and visibility without compromising flexibility. US 2021/202633 A1 shows a high-resolution flexible display device that remains durable against external shocks by incorporating an inorganic insulating layer with grooves filled with organic material to enhance flexibility and robustness. Multiple thin-film transistors, electrode layers, and connecting lines are symmetrically arranged and interconnected across these grooves to maintain electrical continuity and high display performance without compromising structural flexibility.

The above-described information may be provided as a related art for the purpose of helping understanding of the present disclosure. No argument or decision is made as to whether any of the above description may be applied as a prior art related to the present disclosure.

### [Disclosure]

### [Technical Solution]

According to an embodiment, a display may comprise a planar first region. According to an embodiment, the display may comprise a second region, connected to the first region, disposed along a folding axis of the display so as to have a slope relative to the first region. According to an embodiment, the display may comprise a pixel layer including a first sub-pixel disposed in the first region and a second sub-pixel disposed in the second region. According to an embodiment, the display may comprise a light blocking layer disposed on the pixel layer, wherein the light blocking layer includes first blocking portions disposed on the first sub-pixel and spaced apart from each other, and second blocking portions disposed on the second sub-pixel and spaced apart from each other. According to an embodiment, in the display, an area of the first sub-pixel covered by one of the first blocking portions may correspond to an area of the first sub-pixel covered by another of the first blocking portions. According to an embodiment, in the display, an area of the second sub-pixel covered by one of the second blocking portions may be different from an area of the second sub-pixel covered by another of the second blocking portions.

According to an embodiment, an electronic device may comprise a first housing. According to an embodiment, the electronic device may comprise a second housing rotatably coupled to the first housing. According to an embodiment, the electronic device may comprise a display foldable with respect to a folding axis by movement of the second housing relative to the first housing. According to an embodiment, the display may comprise a planar first region. According to an embodiment, the display may comprise a second region, connected to the first region, disposed along a folding axis of the display so as to have a slope relative to the first region. According to an embodiment, the display may comprise a pixel layer including a first sub-pixel disposed in the first region and a second sub-pixel disposed in the second region. According to an embodiment, the display may comprise a light blocking layer disposed on the pixel layer, wherein the light blocking layer includes first blocking portions disposed on the first sub-pixel and spaced apart from each other, and second blocking portions disposed on the second sub-pixel and spaced apart from each other. According to an embodiment, in the display, an area of the first sub-pixel covered by one of the first blocking portions may correspond to an area of the first sub-pixel covered by another of the first blocking portions. According to an embodiment, in the display, an area of the second sub-pixel covered by one of the second blocking portions may be different from an area of the second sub-pixel covered by another of the second blocking portions.

### [Description of the Drawings]

FIG. 1 is a block diagram of an electronic device within a network environment according to various embodiments.
FIG. 2 is a block diagram of a display module according to various embodiments.
FIG. 3A illustrates an example of an unfolding state of an exemplary electronic device according to an embodiment.
FIG. 3B illustrates an example of a folding state of an exemplary electronic device according to an embodiment.
FIG. 3C is an exploded view of an exemplary electronic device according to an embodiment.
FIG. 4A illustrates an example of an unfolding state of an exemplary electronic device according to an embodiment.
FIG. 4B is a cross-sectional view illustrating an example of an exemplary electronic device cut along line A-A' of FIG. 4A.
FIG. 5 is a graph indicating a relationship between a luminance and an angle of each of an exemplary plurality of sub-pixels according to an embodiment.
FIG. 6A is a cross-sectional view illustrating an example of cutting a first region of an exemplary display according to an embodiment.
FIG. 6B is a cross-sectional view illustrating an example of cutting a second region of an exemplary display according to an embodiment.
FIG. 6C is a cross-sectional view illustrating an example of cutting a third region of an exemplary display according to an embodiment.
FIG. 7A is a cross-sectional view illustrating an example of cutting a first region of an exemplary display according to an embodiment.
FIG. 7B is a cross-sectional view illustrating an example of cutting a second region of an exemplary display according to an embodiment.
FIG. 7C is a cross-sectional view illustrating an example of cutting a third region of an exemplary display according to an embodiment.

### [Mode for Invention]

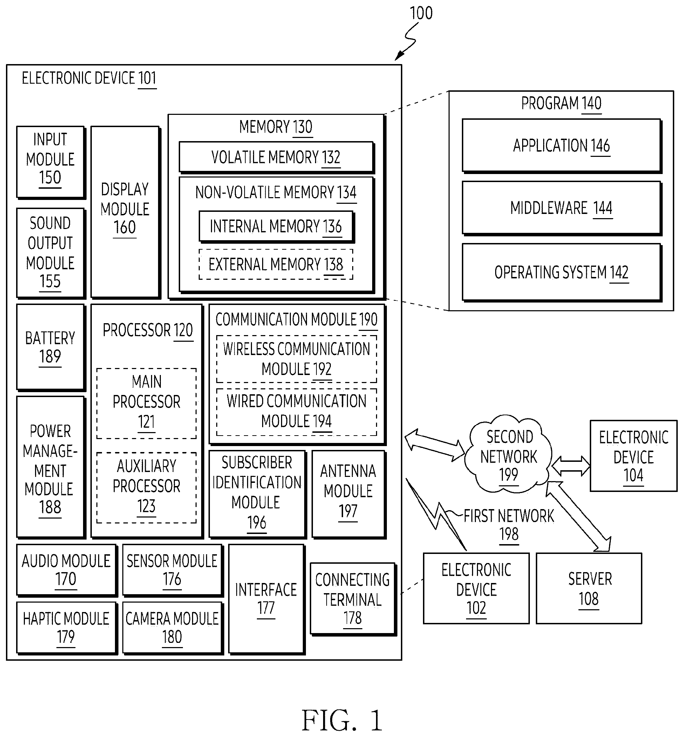

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

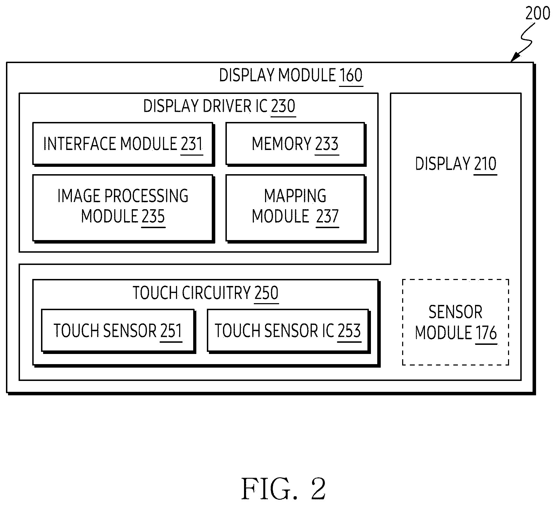

FIG. 2 is a block diagram 200 illustrating the display module 160 according to various embodiments.

Referring to FIG. 2, the display module 160 may include a display 210 and a display driver integrated circuit (DDI) 230 to control the display 210. The DDI 230 may include an interface module 231, memory 233 (e.g., buffer memory), an image processing module 235, or a mapping module 237. The DDI 230 may receive image information that contains image data or an image control signal corresponding to a command to control the image data from another component of the electronic device 101 via the interface module 231. For example, according to an embodiment, the image information may be received from the processor 120 (e.g., the main processor 121 (e.g., an application processor)) or the auxiliary processor 123 (e.g., a graphics processing unit) operated independently from the function of the main processor 121. The DDI 230 may communicate, for example, with touch circuitry 250 or the sensor module 176 via the interface module 231. The DDI 230 may also store at least part of the received image information in the memory 233, for example, on a frame by frame basis. The image processing module 235 may perform pre-processing or post-processing (e.g., adjustment of resolution, brightness, or size) with respect to at least part of the image data. According to an embodiment, the pre-processing or post-processing may be performed, for example, based at least in part on one or more characteristics of the image data or one or more characteristics of the display 210. The mapping module 237 may generate a voltage value or a current value corresponding to the image data preprocessed or post-processed by the image processing module 235. According to an embodiment, the generating of the voltage value or current value may be performed, for example, based at least in part on one or more attributes of the pixels (e.g., an array, such as an RGB stripe or a pentile structure, of the pixels, or the size of each subpixel). At least some pixels of the display 210 may be driven, for example, based at least in part on the voltage value or the current value such that visual information (e.g., a text, an image, or an icon) corresponding to the image data may be displayed via the display 210.

According to an embodiment, the display module 160 may further include the touch circuitry 250. The touch circuitry 250 may include a touch sensor 251 and a touch sensor IC 253 to control the touch sensor 251. The touch sensor IC 253 may control the touch sensor 251 to sense a touch input or a hovering input with respect to a certain position on the display 210. To achieve this, for example, the touch sensor 251 may detect (e.g., measure) a change in a signal (e.g., a voltage, a quantity of light, a resistance, or a quantity of one or more electric charges) corresponding to the certain position on the display 210. The touch circuitry 250 may provide input information (e.g., a position, an area, a pressure, or a time) indicative of the touch input or the hovering input detected via the touch sensor 251 to the processor 120. According to an embodiment, at least part (e.g., the touch sensor IC 253) of the touch circuitry 250 may be formed as part of the display 210 or the DDI 230, or as part of another component (e.g., the auxiliary processor 123) disposed outside the display module 160.

According to an embodiment, the display module 160 may further include at least one sensor (e.g., a fingerprint sensor, an iris sensor, a pressure sensor, or an illuminance sensor) of the sensor module 176 or a control circuit for the at least one sensor. In such a case, the at least one sensor or the control circuit for the at least one sensor may be embedded in one portion of a component (e.g., the display 210, the DDI 230, or the touch circuitry 250)) of the display module 160. For example, when the sensor module 176 embedded in the display module 160 includes a biometric sensor (e.g., a fingerprint sensor), the biometric sensor may obtain biometric information (e.g., a fingerprint image) corresponding to a touch input received via a portion of the display 210. As another example, when the sensor module 176 embedded in the display module 160 includes a pressure sensor, the pressure sensor may obtain pressure information corresponding to a touch input received via a partial or whole area of the display 210. According to an embodiment, the touch sensor 251 or the sensor module 176 may be disposed between pixels in a pixel layer of the display 210, or over or under the pixel layer.

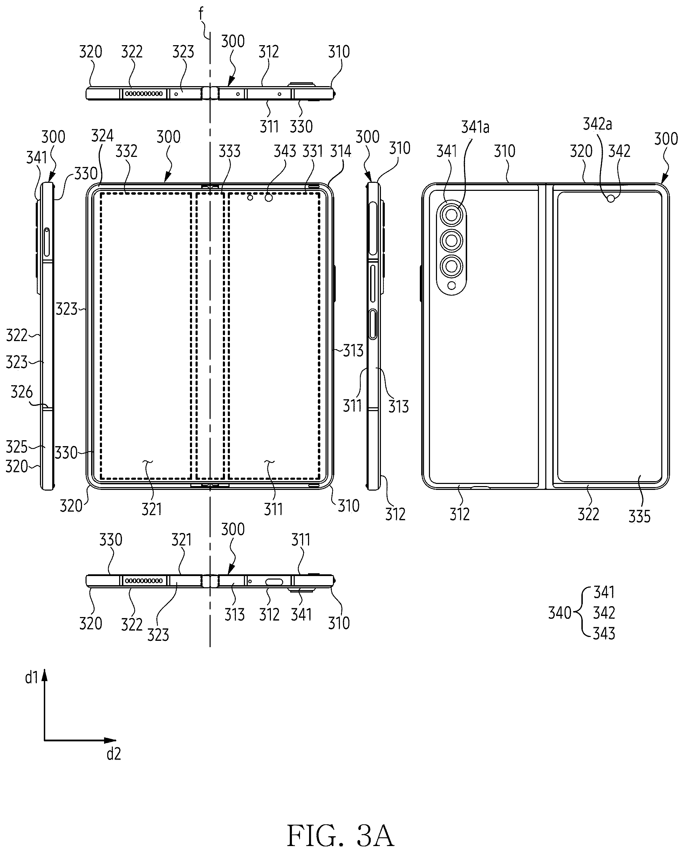

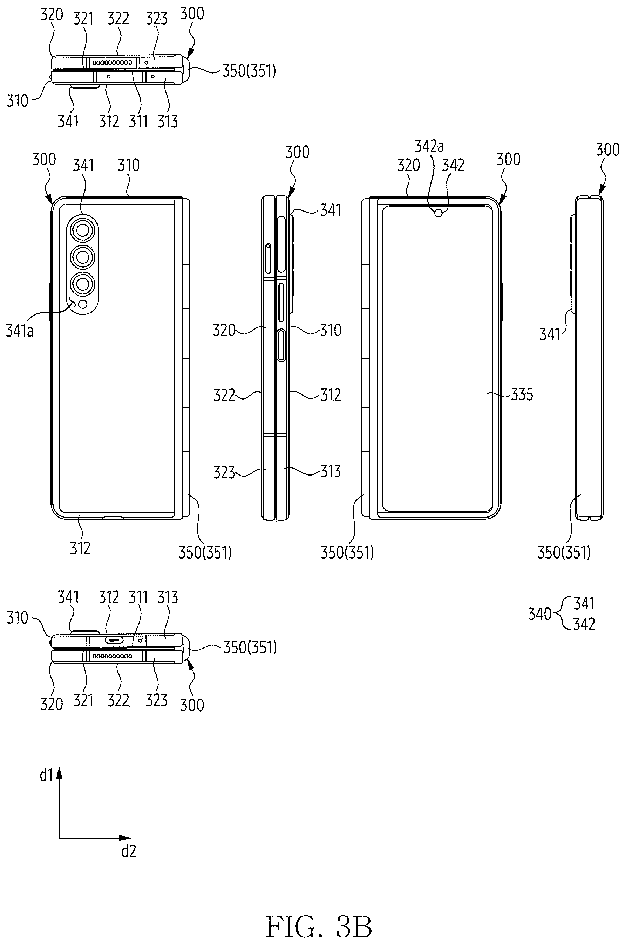

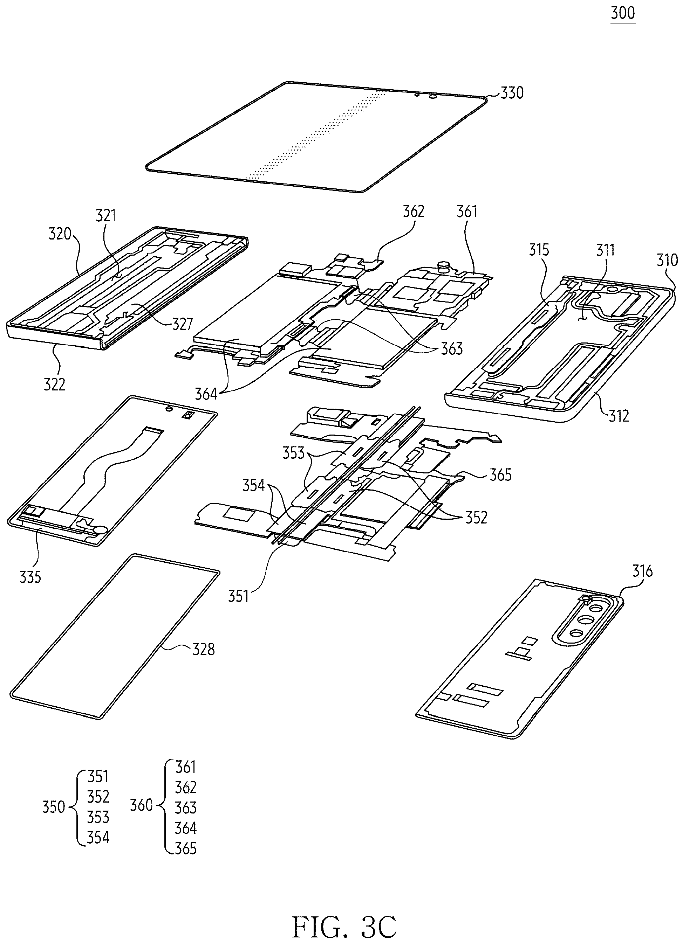

FIG. 3A illustrates an example of an unfolding state of an exemplary electronic device according to an embodiment, FIG. 3B illustrates an example of a folding state of an exemplary electronic device according to an embodiment, and FIG. 3C is an exploded view of an exemplary electronic device according to an embodiment.

Referring to FIG. 3A, FIG. 3B, and FIG. 3C, an electronic device 300 (e.g., the electronic device 101 of FIG. 1) may include a first housing 310, a second housing 320, a display 330 (e.g., the display 210 of FIG. 2), at least one camera 340 (e.g., the camera module 180 of FIG. 1), a hinge structure 350, and/or at least one electronic component 360.

The first housing 310 and the second housing 320 may form at least a portion of an outer surface of the electronic device 300 that may be gripped by a user. When the electronic device 300 is used by the user, the at least a portion of the outer surface of the electronic device 300 defined by the first housing 310 and the second housing 320 may be in contact with a portion of a body of the user. According to an embodiment, the first housing 310 may include a first surface 311, a second surface 312 facing the first surface 311 and spaced apart from the first surface 311, and a first side surface 313 surrounding at least a portion of the first surface 311 and the second surface 312. The first side surface 313 may connect a periphery of the first surface 311 to a periphery of the second surface 312. The first surface 311, the second surface 312, and the first side surface 313 may define an inner space of the first housing 310. According to an embodiment, the first housing 310 may provide a space formed by the first surface 311, the second surface 312, and the first side surface 313 as a space for disposing components of the electronic device 300.

According to an embodiment, the second housing 320 may include a third surface 321, a fourth surface 322 facing the third surface 321 and spaced apart from the third surface 321, and a second side surface 323 surrounding at least a portion of the third surface 321 and the fourth surface 322. The second side surface 323 may connect a periphery of the third surface 321 to a periphery of the fourth surface 322. The third surface 321, the fourth surface 322, and the second side surface 323 may define an inner space of the second housing 320. According to an embodiment, the second housing 320 may provide a space formed by the third surface 321, the fourth surface 322, and the second side surface 323 surrounding at least a portion of the third surface 321 and the fourth surface 322, as a space for mounting components of the electronic device 101. According to an embodiment, the second housing 320 may be coupled to the first housing 310 to be rotatable relative to the first housing 310.

According to an embodiment, each of the first housing 310 and the second housing 320 may include each of a first protective portion 314 and a second protective portion 324. The first protective portion 314 and the second protective portion 324 may be disposed on the first surface 311 and the third surface 321 along a periphery of the display 330. According to an embodiment, the first protective portion 314 and the second protective portion 324 may prevent an inflow of a foreign substance (e.g., dust or moisture) through a gap between the display 330 and the first housing 310 and the second housing 320. For example, the first protective portion 314 may surround a periphery of a first display region 331 of the display 330, and the second protective portion 324 may surround a periphery of a second display region 332 of the display 330. The first protective portion 314 may be formed by being attached to the first side surface 313 of the first housing 310 or may be formed integrally with the first side surface 313. The second protective portion 324 may be formed by being attached to the second side surface 323 of the second housing 320 or may be integrally formed with the second side surface 323.

According to an embodiment, the first side surface 313 and the second side surface 323 may include a conductive material, a non-conductive material, or a combination thereof. For example, the second side surface 323 may include at least one conductive portion 325 and at least one non-conductive portion 326. The at least one conductive portion 325 may include a plurality of conductive portions spaced apart from each other. The at least one non-conductive portion 326 may be disposed between a plurality of conductive portions. The plurality of conductive portions may be disconnected from each other by the at least one non-conductive portion 326 disposed between the plurality of conductive portions. According to an embodiment, the plurality of conductive portions and a plurality of non-conductive portions may form an antenna radiator together. The electronic device 300 may communicate with an external electronic device through the antenna radiator formed by the plurality of conductive portions and the plurality of non-conductive portions.

The display 330 may be configured to display visual information. According to an embodiment, the display 330 may be disposed on the first surface 311 of the first housing 310 and the third surface 321 of the second housing 320 across the hinge structure 350. For example, the display 330 may include the first display region 331 disposed on the first surface 311 of the first housing, the second display region 332 disposed on the third surface 321 of the second housing, and a third display region 333 disposed between the first display region 331 and the second display region 332. The first display region 331, the second display region 332, and the third display region 333 may form a front surface of the display 330. According to an embodiment, the display 330 may further include a sub-display panel 335 disposed on the fourth surface 322 of the second housing 320. For example, the display 330 may be referred to as a flexible display. According to an embodiment, the display 330 may include a window exposed toward the outside of the electronic device 300. The window may protect an external surface of the display 330, and transmit visual information provided by the display 330 to the outside of the electronic device 300, by including a substantially transparent material. For example, the window may include glass (e.g., ultra-thin glass (UTG)) and/or polymer (e.g., polyimide (PI)), but is not limited thereto.

The at least one camera 340 may be configured to obtain an image based on receiving light from an external subject of the electronic device 300. According to an embodiment, the at least one camera 340 may include first cameras 341, a second camera 342, and a third camera 343. The first cameras 341 may be disposed in the first housing 310. For example, the first cameras 341 may be disposed inside the first housing 310, and at least a portion may be visible through the second surface 312 of the first housing 310. The first cameras 341 may be supported by a bracket (not illustrated) in the first housing 310. When the second surface 412 is viewed from above, the first housing 310 may include at least one opening 341a that overlaps the first cameras 341. The first cameras 341 may obtain an image based on receiving light from the outside of the electronic device 300 through the at least one opening 341a.

According to an embodiment, the second camera 342 may be disposed in the second housing 320. For example, the second camera 342 may be disposed inside the second housing 320 and may be visible through the sub-display panel 335. When the fourth surface 322 is viewed from above, the second housing 320 may include at least one opening 342a that overlaps the second camera 342. The second camera 342 may obtain an image based on receiving light from the outside of the electronic device 300 through the at least one opening 342a.

According to an embodiment, the third camera 343 may be disposed in the first housing 310. For example, the third camera 343 is disposed inside the first housing 310, and at least a portion may be visible through the first surface 311 of the first housing 310. For another example, the third camera 343 is disposed inside the first housing 310, and at least a portion may be visible through the first display region 331 of the display 330. When the display 330 is viewed from above, the first display region 331 of the display 330 may include at least one opening (not illustrated) that overlaps the third camera 343. The third camera 343 may obtain an image based on receiving light from the outside of the display 330 through the at least one opening.

According to an embodiment, the second camera 342 and the third camera 343 may be disposed below (e.g., a direction toward the inside of the first housing 310 or the inside of the second housing 320) the display 330. For example, the second camera 342 and the third camera 343 may be an under display camera (UDC). In case that the second camera 342 and the third camera 343 are the under-display camera, a region of the display 330 corresponding to a position of each of the second camera 342 and the third camera 343 may not be an inactive region. For example, in case that the second camera 342 and the third camera 343 are the under-display camera, the region of the display 330 corresponding to the position of each of the second camera 342 and the third camera 343 may have a lower pixel density than a pixel density of another region of the display 330. The inactive region of the display 330 may mean a region of the display 330 that does not include a pixel or does not emit light to the outside of the electronic device 300. For another example, the second camera 342 and the third camera 343 may be a punch hole camera. In case that the second camera 342 and the third camera 343 are the punch hole camera, the region of the display 330 corresponding to the position of each of the second camera 342 and the third camera 343 may be the inactive region. For example, in case that the second camera 342 and the third camera 343 are the punch hole camera, the region of the display 330 corresponding to the position of each of the second camera 342 and the third camera 343 may include an opening that does not include a pixel.

According to an embodiment, the hinge structure 350 may rotatably connect the first housing 310 and the second housing 320. The hinge structure 350 may be disposed between the first housing 310 and the second housing 320 of the electronic device 101 so that the electronic device 300 may be bent, curved, or folded. For example, the hinge structure 350 may be disposed between a portion of the first side surface 313 and a portion of the second side surface 323 facing each other. The hinge structure 350 may change the electronic device 300 into the unfolding state in which the first surface 311 of the first housing 310 and the third surface 321 of the second housing 320 face substantially the same direction, or the folding state in which the first surface 311 and the third surface 321 face each other. When the electronic device 300 is in the folding state, the first housing 310 and the second housing 320 may be covered or overlapped by facing each other.

According to an embodiment, when the electronic device 300 is in the folding state, a direction in which the first surface 311 faces and a direction in which the third surface 321 faces may be different from each other. For example, when the electronic device 300 is in the folding state, the direction in which the first surface 311 faces and the direction in which the third surface 321 faces may be opposite to each other. For another example, when the electronic device 300 is in the folding state, the direction in which the first surface 311 faces and the direction in which the third surface 321 faces may be inclined relative to each other. In case that the direction in which the first surface 311 faces is inclined relative to the direction in which the third surface 321 faces, the first housing 310 may be inclined relative to the second housing 320.

According to an embodiment, the electronic device 300 may be foldable with respect to a folding axis f. The folding axis f may mean an imaginary line extending over a hinge cover 351 in a direction (e.g., d1 of FIG. 3A and FIG. 3B) substantially parallel to a longitudinal direction of the electronic device 300, but is not limited thereto. For example, the folding axis f may be an imaginary line extending in a direction (e.g., d2 of FIG. 3A and FIG. 3B) substantially perpendicular to the longitudinal direction of the electronic device 300. In case that the folding axis f extends in the direction substantially perpendicular to the longitudinal direction of the electronic device 300, the hinge structure 350 may extend in a direction parallel to the folding axis f to connect the first housing 310 and the second housing 320. The first housing 310 and the second housing 320 may be rotatable by the hinge structure 350 extending in the direction substantially perpendicular to the longitudinal direction of the electronic device 300.

According to an embodiment, the hinge structure 350 may include the hinge cover 351, a first hinge plate 352, a second hinge plate 353, and a hinge module 354. The hinge cover 351 may surround internal components of the hinge structure 350 and form an outer surface of the hinge structure 350. According to an embodiment, when the electronic device 300 is in the folding state, the hinge cover 351 surrounding the hinge structure 350 may be at least partially exposed to the outside of the electronic device 300 through a space between the first housing 310 and the second housing 320. According to an embodiment, when the electronic device 300 is in the unfolding state, the hinge cover 351 may be covered by the first housing 310 and the second housing 320 and then may not be exposed to the outside of the electronic device 300.

According to an embodiment, the first hinge plate 352 and the second hinge plate 353 may rotatably connect the first housing 310 and the second housing 320, by being coupled to the first housing 310 and the second housing 320, respectively. For example, the first hinge plate 352 may be coupled with a first front bracket 315 of the first housing 310, and the second hinge plate 353 may be coupled with a second front bracket 327 of the second housing 320. As the first hinge plate 352 and the second hinge plate 353 are coupled to the first front bracket 315 and the second front bracket 327, respectively, the first housing 310 and the second housing 320 may be rotatable according to rotation of the first hinge plate 352 and the second hinge plate 353.

The hinge module 354 may rotate the first hinge plate 352 and the second hinge plate 353. For example, the hinge module 354 may rotate the first hinge plate 352 and the second hinge plate 353 with respect to the folding axis f, by including gears that are rotatable by being engaged with each other. According to an embodiment, the hinge modules 354 may be a plural. For example, a plurality of hinge modules 354 may be disposed to be spaced apart from each other at both ends of the first hinge plate 352 and the second hinge plate 353, respectively.

According to an embodiment, the first housing 310 may include the first front bracket 315 and a first rear bracket 316, and the second housing 320 may include the second front bracket 327 and a second rear bracket 328. The first front bracket 315 and the first rear bracket 316 may support the components of the electronic device 300. The first front bracket 315 may define the first housing 310, by being coupled to the first rear bracket 316. The first rear bracket 316 may define a portion of an outer surface of the first housing 310. The second front bracket 327 and the second rear bracket 328 may support the components of the electronic device 300. The second front bracket 327 may define the second housing 320, by being coupled to the second rear bracket 328. The second rear bracket 328 may define a portion of an outer surface of the second housing 320. For example, the display 330 may be disposed on a surface of the first front bracket 315 and a surface of the second front bracket 327. The first rear bracket 316 may be disposed on another surface of the first front bracket 315 opposite to the surface of the first front bracket 315. The second rear bracket 328 may be disposed on another surface of the second front bracket 327 opposite to the surface of the second front bracket 327. The sub-display panel 335 may be disposed between the second front bracket 327 and the second rear bracket 328.

According to an embodiment, a portion of the first front bracket 315 may be surrounded by the first side surface 313, and a portion of the second front bracket 327 may be surrounded by the second side surface 323. For example, the first front bracket 315 may be integrally formed with the first side surface 313, and the second front bracket 327 may be integrally formed with the second side surface 323. For another example, the first front bracket 315 may be formed separately from the first side surface 313, and the second front bracket 327 may be formed separately from the second side surface 323.

The at least one electronic component 360 may implement various functions to be provided to the user. According to an embodiment, the at least one electronic component 360 may include a first printed circuit board 361, a second printed circuit board 362, a flexible printed circuit board 363, a battery 364 (e.g., the battery 189 of FIG. 1), and/or an antenna 365 (e.g., the antenna module 197 of FIG. 1). Each of the first printed circuit board 361 and the second printed circuit board 362 may form an electrical connection between components in the electronic device 300. For example, components (e.g., the processor 120 of FIG. 1) for implementing an overall function of the electronic device 300 may be disposed on the first printed circuit board 361, and electronic components for implementing a partial function of the first printed circuit board 361 may be disposed on the second printed circuit board 362. For another example, components for an operation of the sub-display panel 335 disposed on the fourth surface 322 may be disposed on the second printed circuit board 362.

According to an embodiment, the first printed circuit board 361 may be disposed in the first housing 310. For example, the first printed circuit board 361 may be disposed on a surface of the first front bracket 315. According to an embodiment, the second printed circuit board 362 may be disposed in the second housing 320. For example, the second printed circuit board 362 may be spaced apart from the first printed circuit board 361 and disposed on a surface of the second front bracket 327. The flexible printed circuit board 363 may connect the first printed circuit board 361 and the second printed circuit board 362. For example, the flexible printed circuit board 363 may extend from the first printed circuit board 361 to the second printed circuit board 362.

The battery 364 is a device for supplying power to at least one component of the electronic device 300, and may include, for example, a non-rechargeable primary battery, a rechargeable secondary battery, or a fuel cell. At least a portion of the battery 364 may be disposed on substantially the same plane as the first printed circuit board 361 or the second printed circuit board 362.

The antenna 365 may be configured to receive power or a signal from the outside of the electronic device 300. According to an embodiment, the antenna 365 may be disposed between the first rear bracket 316 and the battery 364. The antenna 365 may include, for example, a near field communication (NFC) antenna, an antenna module, and/or a magnetic secure transmission (MST) antenna. For example, the antenna 365 may perform short-range communication with an external device or wirelessly transmit and receive power required for charging.

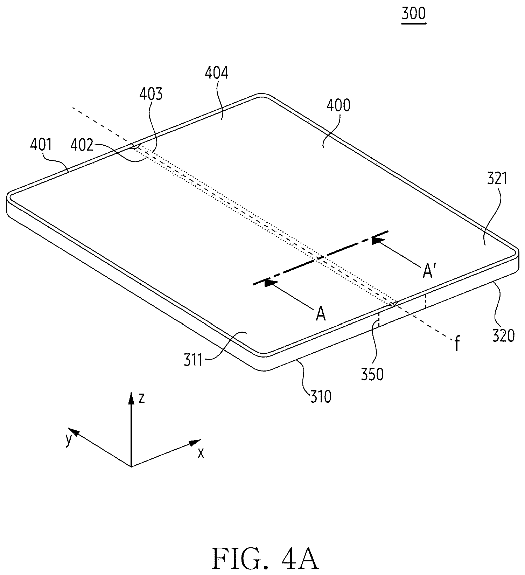

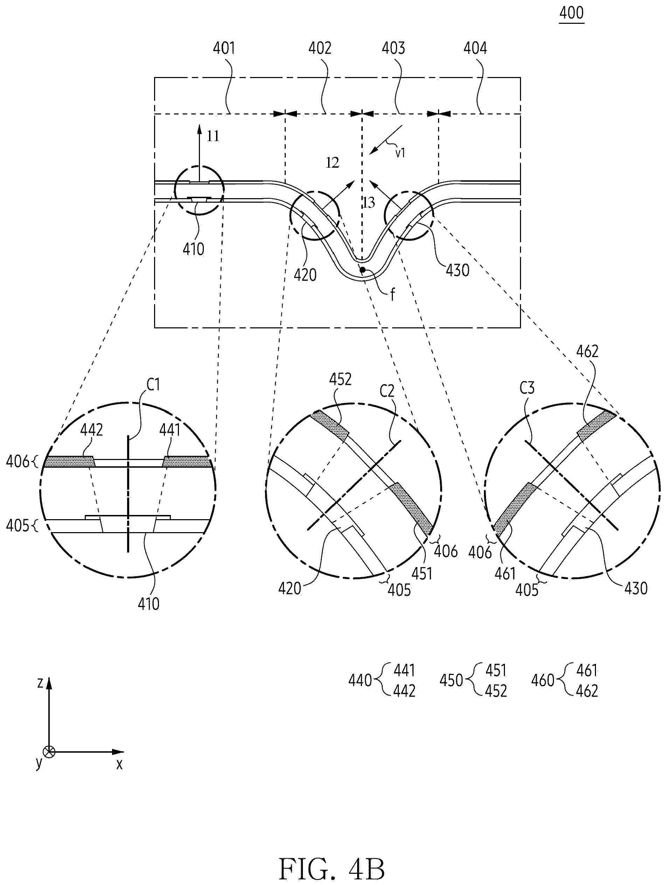

FIG. 4A illustrates an example of an unfolding state of an exemplary electronic device according to an embodiment, and FIG. 4B illustrates an example of cutting an exemplary electronic device according to an embodiment along A-A' of FIG. 4A.

Referring to FIG. 4A and FIG. 4B, an electronic device 300 according to an embodiment may include a first housing 310, a second housing 320, a hinge structure 350, and/or a display 400 (e.g., the display 210 of FIG. 2, and the display 330 of FIG. 3A, FIG. 3B, and FIG. 3C).

According to an embodiment, the first housing 310 and the second housing 320 may be coupled to be rotatable relative to each other through the hinge structure 350. For example, in a folding state of the electronic device 300, a first surface 311 and a third surface 321 of the first housing 310 may face each other. For example, in an unfolding state of the electronic device 300, a direction (e.g., a +z direction) in which the first surface 311 of the first housing 310 faces may be substantially the same as a direction (e.g., a +z direction) in which the third surface 321 of the second housing 320 faces. As the first housing 310 and the second housing 320 move relative to each other, the display 400 may be folded or unfolded. For example, in the unfolding state of the electronic device 300, the display 400 may be unfolded. For example, in the folding state of electronic device 300, the display 400 may be folded. According to an embodiment, the display 400 may be folded or unfolded with respect to a folding axis f by movement of the second housing 320 relative to the first housing 310.

According to an embodiment, the display 400 may include a first region 401, a second region 402, a third region 403, a fourth region 404, a pixel layer 405, and/or a light blocking layer 406. According to an embodiment, the display 400 may be referred to as an organic light emitting diodes (OLED) display, but is not limited thereto.

According to an embodiment, at least a portion of the first region 401 may be disposed on the first housing 310. For example, the first region 401 may be disposed only on the first housing 310. For example, the first region 401 may be disposed on the first housing 310 and a portion of the hinge structure 350. According to an embodiment, the first region 401 may be substantially planar. For example, in the unfolding state of the electronic device 300, the first region 401 may be substantially planar. According to an embodiment, the first region 401 may include a plurality of pixels configured to emit light for providing visual information. The plurality of pixels in the first region 401 may emit the light for providing the visual information based on receiving a control signal from a display driving circuit (e.g., the DDI 230 of FIG. 2).

According to an embodiment, the second region 402 may be connected to the first region 401. According to an embodiment, the second region 402 may have a slope relative to the first region 401. For example, the second region 402 may be inclined relative to the first region 401. For example, the second region 402 may be curved to have the slope relative to the first region 401. For example, in the unfolding state of the electronic device 300, the second region 402 may have the slope relative to the first region 401. According to an embodiment, the second region 402 may extend in a direction from the first region 401 toward the folding axis f. For example, the second region 402 may extend from the first region 401 in a direction approaching the folding axis f so as to be inclined relative to the first region 401. According to an embodiment, the second region 402 may mean a region of the display 400 adjacent to the folding axis f. For example, the second region 402 may be disposed along the folding axis f. According to an embodiment, the second region 402 may include a plurality of pixels configured to emit light for providing visual information. The plurality of pixels in the first region 401 may emit the light for providing the visual information based on receiving the control signal from the display driving circuit (e.g., the DDI 230 of FIG. 2). According to an embodiment, the second region 402 may be formed by repeating folding or unfolding of the display 400. For example, the second region 402 may be formed by plastic deformation of a portion of the display 400 due to stress generated by repeating folding or unfolding of the display 400. The plastic deformation may mean that the second region 402 maintains a specific shape even after a force for deforming the second region 402 into the specific shape is removed.

According to an embodiment, the third region 403 may be connected to the second region 402. According to an embodiment, the third region 403 may have a slope relative to the first region 401 and the second region 402. For example, the third region 403 may be inclined relative to the first region 401 and the second region 402. For example, the third region 403 may be curved to have the slope relative to the first region 401 and the second region 402. For example, in the unfolding state of the electronic device 300, the third region 403 may have the slope relative to the first region 401 and the second region 402. According to an embodiment, the third region 403 may extend in a direction from the folding axis f toward the fourth region 404. For example, the third region 403 may extend from the second region 402 along a direction away from the folding axis f so as to have a slope relative to the second region 402. According to an embodiment, the third region 403 may mean another region of the display 400 adjacent to the folding axis f. For example, the third region 403 may be disposed along the folding axis f. According to an embodiment, the folding axis f may be positioned between the second region 402 and the third region 403. For example, the folding axis f may be positioned at a boundary between the second region 402 and the third region 403. According to an embodiment, the third region 403 may include a plurality of pixels configured to emit light for providing visual information. The plurality of pixels in the third region 403 may emit the light for providing the visual information based on receiving the control signal from the display driving circuit (e.g., the DDI 230 of FIG. 2). According to an embodiment, the third region 403 may be formed by repeating folding or unfolding of the display 400. For example, the third region 403 may be formed by plastic deformation of a portion of the display 400 due to stress generated by repeating folding or unfolding of the display 400. The plastic deformation may mean that the third region 403 maintains a specific shape even after a force for deforming the third region 403 into the specific shape is removed.

According to an embodiment, the fourth region 404 may be spaced apart from the first region 401. At least a portion of the fourth region 404 may be disposed on the second housing 320. For example, the fourth region 404 may be disposed only on the second housing 320. For example, the fourth region 404 may be disposed on the second housing 320 and another portion of the hinge structure 350. According to an embodiment, the fourth region 404 may be substantially planar. For example, in the unfolding state of the electronic device 300, the fourth region 404 may be substantially planar. For example, the fourth region 404 may be substantially parallel to the first region 401. According to an embodiment, the fourth region 404 may move relative to the first region 401. For example, the fourth region 404 may move relative to the first region 401 by rotation of the second housing 320 relative to the first housing 310. According to an embodiment, the fourth region 404 may be connected to the third region 403. For example, the fourth region 404 may extend in a direction away from the third region 403 with respect to the folding axis f.

According to an embodiment, the pixel layer 405 may be disposed inside the display 400. For example, the pixel layer 405 may be disposed in the first region 401, the second region 402, the third region 403, and/or the fourth region 404. The pixel layer 405 may be included in the first region 401, the second region 402, the third region 403, and/or the fourth region 404. According to an embodiment, the pixel layer 405 may include a plurality of sub-pixels. The plurality of sub-pixels may be disposed in the first region 401, the second region 402, the third region 403, and/or the fourth region 404. Each of the plurality of sub-pixels may provide a specified color. For example, each of the plurality of sub-pixels may provide red light, green light, and/or blue light. The plurality of sub-pixels may define a pixel. For example, the pixel may include one sub-pixel for emitting the red light, two sub-pixels for emitting the green light, and/or one sub-pixel for emitting the blue light. For example, the pixel may include one sub-pixel for emitting the red light, one sub-pixel for emitting the green light, and/or one sub-pixel for emitting the blue light.

According to an embodiment, the pixel layer 405 may include a first sub-pixel 410, a second sub-pixel 420, and/or a third sub-pixel 430. The first sub-pixel 410 may be included in the first region 401. The first sub-pixel 410 may be disposed in the first region 401. The second sub-pixel 420 may be included in the second region 402. The second sub-pixel 420 may be disposed in the second region 402. The second sub-pixel 420 may have a slope relative to the first sub-pixel 410 by being disposed in the second region 402 having the slope relative to the first region 401. A first direction l1 in which the first sub-pixel 410 faces may be inclined relative to a second direction l2 in which the second sub-pixel 420 faces. The third sub-pixel 430 may be included in the third region 403. The third sub-pixel 430 may be disposed in the third region 403. The third sub-pixel 430 may have a slope relative to the first sub-pixel 410 and/or the second sub-pixel 420 by being disposed in the third region 403 having the slope relative to the first region 401 and the second region 402. For example, a third direction l3 in which the third sub-pixel 430 faces may be inclined relative to the second direction l2 in which the second sub-pixel 420 faces and the first direction 11 in which the first sub-pixel 410 faces.

According to an embodiment, the light blocking layer 406 may block a portion of the light emitted from the plurality of sub-pixels. According to an embodiment, the light blocking layer 406 may be disposed on the pixel layer 405. According to the invention, the light blocking layer 406 is disposed above the pixel layer 405. For example, the light blocking layer 406 may be spaced apart from the pixel layer 405. According to an embodiment, the light blocking layer 406 may include first blocking portions 440, second blocking portions 450, and/or third blocking portions 460.

According to an embodiment, the first blocking portions 440 may be disposed in the first region 401. The first blocking portions 440 may block a portion of the light emitted from the plurality of sub-pixels disposed in the first region 401. For example, the first blocking portions 440 may be referred to as a black matrix (BM). According to an embodiment, each of the first blocking portions 440 may be disposed on the first sub-pixel 410. According to the invention, each of the first blocking portions 440 is disposed above the first sub-pixel 410. The first blocking portions 440 may be spaced apart from each other. For example, one 441 of the first blocking portions 440 may be spaced apart from another 442 of the first blocking portions 440. For example, a distance between the folding axis f and the one 441 of the first blocking portions 440 may be shorter than a distance between the folding axis f and the other 442 of the first blocking portions 442.

According to an embodiment, the first blocking portions 440 may be symmetrical with respect to the first sub-pixel 410. An area of the first sub-pixel 410 covered by the one 441 of the first blocking portions 440 may correspond to an area of the first sub-pixel 410 covered by the other 442 of the first blocking portions 440. The area of the first sub-pixel 410 covered by the one 441 of the first blocking portions 440 may be substantially the same as the area of the first sub-pixel 410 covered by the other 442 of the first blocking portions 440. For example, when the first sub-pixel 410 is viewed from above, the area of the first sub-pixel 410 covered by the one 441 of the first blocking portions 440 may correspond to the area of the first sub-pixel 410 covered by the other 442 of the first blocking portions 440. For example, when the first sub-pixel 410 is viewed in a direction opposite to the first direction 11 in which the first sub-pixel 410 faces, the area of the first sub-pixel 410 covered by the one 441 of the first blocking portions 440 may correspond to the area of the first sub-pixel 410 covered by the other 442 of the first blocking portions 440. According to an embodiment, as the first blocking portions 440 are disposed symmetrically relative to the first sub-pixel 410, a portion of a viewing angle of the first sub-pixel 410 close to the folding axis f may be substantially the same as another portion that is farthest from the folding axis f, with respect to a center c1 of the first sub-pixel 410.

According to an embodiment, the second blocking portions 450 may be disposed in the second region 402. The second blocking portions 450 may block a portion of the light emitted from the plurality of sub-pixels disposed in the second region 402. For example, the second blocking portions 450 may be referred to as the black matrix (BM). According to an embodiment, the second blocking portions 450 may be disposed on the second sub-pixel 420. The second blocking portions 450 may be disposed above the second sub-pixel 420. The second blocking portions 450 may be spaced apart from each other. For example, one 451 of the second blocking portions 450 may be spaced apart from another 452 of the second blocking portions 450. For example, a distance between the folding axis f and the one 451 of the second blocking portions 450 may be shorter than a distance between the folding axis f and the other 452 of the second blocking portions 450.

According to an embodiment, the second blocking portions 450 may be asymmetrical with respect to the second sub-pixel 420. An area of the second sub-pixel 420 covered by the one 451 of the second blocking portions 450 may be different from an area of the second sub-pixel 420 covered by the other 452 of the second blocking portions 450. For example, the area of the second sub-pixel 420 covered by the one 451 of the second blocking portions 450 may be larger than the area of the second sub-pixel 420 covered by the other 452 of the second blocking portions 450. For example, when the second sub-pixel 420 is viewed in a direction v1 opposite to the second direction l2 in which the second sub-pixel 420 faces, the area of the second sub-pixel 420 covered by the other 452 of the second blocking portions 450 may be smaller than the area of the second sub-pixel 420 covered by the one 451 of the second blocking portions 450. For example, when the second sub-pixel 420 is viewed in the direction v1 opposite to the second direction l2, the one 451 of the second blocking portions 450 may overlap a portion of the second sub-pixel 420. For example, when the second sub-pixel 420 is viewed in the direction v1 opposite to the second direction l2, the other 452 of the second blocking portions 450 may be spaced apart from the second sub-pixel 420.

According to an embodiment, as the second blocking portions 450 are asymmetrically disposed relative to the second sub-pixel 420, a portion of a viewing angle of the second sub-pixel 420 close to the folding axis f may be smaller than another portion that is farthest from the folding axis f, with respect to a center c2 of the second sub-pixel 420. With respect to the center c2 of the second sub-pixel 420, the portion of the viewing angle of the second sub-pixel 420 close to the folding axis f may be reduced by the one 451 of the second blocking portions 450. For example, in case that the second blocking portions 450 are symmetrically disposed with respect to the second sub-pixel 420, in a state in which the display 400 is viewed in the direction v1 opposite to the second direction l2, since a luminance of light emitted from a center of a sub-pixel is greater than a luminance of light emitted from a periphery of the sub-pixel, a luminance of light from the second sub-pixel 420 emitted through the light blocking layer 406 may be greater than a luminance of light from the first sub-pixel 410 emitted through the light blocking layer 406. In case that a difference occurs between a luminance of light emitted from the first sub-pixel 410 and a luminance of light emitted from the second sub-pixel 420, a difference may occur between a luminance of light emitted from the first region 401 and a luminance of light emitted from the second region 402. In case that the difference in the luminance between the first region 401 and the second region 402 occurs, the display 400 may non-uniformly provide visual information to a user. According to an embodiment, the display 400 may provide a structure for providing uniform visual information by the second blocking portions 450 that are asymmetrically disposed. For example, as the second blocking portions 450 are asymmetrically disposed with respect to the second sub-pixel 420, the portion of the viewing angle of the second sub-pixel 420 close to the folding axis f may be reduced by the one 451 of the second blocking portions 450. As the viewing angle of the second sub-pixel 420 close to the folding axis f is reduced, a luminance of the second sub-pixel 420 in the second direction l2 may be relatively reduced. As the luminance in the second direction l2 is relatively reduced, the difference between the luminance of the first sub-pixel 410 and the luminance of the second sub-pixel 420 may be reduced in a state in which the display 400 is viewed in the direction v1 opposite to the second direction l2.

According to an embodiment, the third blocking portions 460 may be disposed in the third region 403. The third blocking portions 460 may block a portion of the light emitted from the plurality of sub-pixels disposed in the third region 403. For example, the third blocking portions 460 may be referred to as the black matrix (BM). The third blocking portions 460 may block a portion of light emitted from the third sub-pixel 430. According to an embodiment, the third blocking portions 460 may be disposed on the third sub-pixel 430. The third blocking portions 460 may be disposed above the third sub-pixel 430. The third blocking portions 460 may be spaced apart from each other. For example, one 461 of the third blocking portions 460 may be spaced apart from another 462 of the third blocking portions 460. For example, a distance between the folding axis f and the one 461 of the third blocking portions 460 may be shorter than a distance between the folding axis f and the other 462 of the third blocking portions 460.

According to an embodiment, the third blocking portions 460 may be asymmetrical with respect to the third sub-pixel 430. An area of the third sub-pixel 430 covered by the one 461 of the third blocking portions 460 may be different from an area of the third sub-pixel 430 covered by the other 462 of the third blocking portions 460. For example, the area of the third sub-pixel 430 covered by the one 461 of the third blocking portions 460 may be larger than the area of the third sub-pixel 430 covered by the other 462 of the third blocking portions 460. For example, when the third sub-pixel 430 is viewed in a direction opposite to the third direction l3 in which the third sub-pixel 430 faces, the area of the third sub-pixel 430 covered by the other 462 of the third blocking portions 460 may be smaller than the area of the third sub-pixel 430 covered by the one 461 of the third blocking portions 460. For example, when the third sub-pixel 430 is viewed in the direction opposite to the third direction l3, the one 461 of the third blocking portions 460 may overlap the third sub-pixel 430. For example, when the third sub-pixel 430 is viewed in the direction opposite to the third direction l3, the other 462 of the third blocking portions 460 may be spaced apart from the third sub-pixel 430.

According to an embodiment, as the third blocking portions 460 are asymmetrically disposed relative to the third sub-pixel 430, a portion of a viewing angle of the third sub-pixel 430 close to the folding axis f may be smaller than another portion that is farthest from the folding axis f with respect to a center c3 of the third sub-pixel 430. With respect to the center c3 of the third sub-pixel 430, the portion of the viewing angle of the third sub-pixel 430 close to the folding axis f may be reduced by the one 461 of the third blocking portions 460. For example, in case that the third blocking portions 460 are symmetrically disposed with respect to the third sub-pixel 430, in a state in which the display 400 is viewed in the direction v1 opposite to the second direction l2, a luminance of light from the third sub-pixel 430 emitted through the light blocking layer 406 may be greater than the luminance of the light from the first sub-pixel 410 emitted through the light blocking layer 406. In case that a difference occurs between the luminance of the light emitted from the first sub-pixel 410 and a luminance of light emitted from the third sub-pixel 430, a difference may occur between the luminance of the light emitted from the first region 401 and a luminance of light emitted from the third region 403. In case that the difference in the luminance between the first region 401 and the third region 403 occurs, the display 400 may non-uniformly provide visual information to the user. According to an embodiment, the display 400 may provide a structure for providing uniform visual information by the third blocking portions 460 that are asymmetrically disposed. For example, as the third blocking portions 460 are asymmetrically disposed with respect to the third sub-pixel 430, the other portion of the viewing angle of the third sub-pixel 430 that is farthest from the folding axis f may be relatively expanded. As the other portion of the viewing angle of the third sub-pixel 430 that is farthest from the folding axis f is relatively expanded, a luminance of the third sub-pixel 430 in the second direction l2 may be relatively increased. As the luminance of the third sub-pixel 430 in the second direction l2 is relatively increased, the difference between the luminance of the first sub-pixel 410 and the luminance of the third sub-pixel 430 may be reduced in a state in which the display 400 is viewed in the direction v1 opposite to the second direction l2.

As described above, the display 400 according to an embodiment may provide a structure capable of reducing the difference in the luminance between the first region 401 and the second region 402 by the second blocking portions 450 asymmetrically disposed relative to the second sub-pixel 420. The display 400 according to an embodiment may provide a structure capable of reducing the difference in the luminance between the first region 401 and the third region 403 by the third blocking portions 460 asymmetrically disposed relative to the third sub-pixel 430. The display 400 according to an embodiment may provide a structure capable of providing uniform visual information as the difference in the luminance between the first region 401, the second region 402, and the third region 403 is reduced.

Meanwhile, FIG. 4B illustrates that one of the sub-pixels 410, 420, and 430 is disposed in each of the regions 401, 402, and 403, but this is for convenience of explanation. For example, structures including substantially the same structure as the first sub-pixel 410 and the first blocking portions 440 may be repeated in the first region 401. For example, structures including substantially the same structure as the second sub-pixel 420 and the second blocking portions 450 may be repeated in the second region 402. For example, structures including substantially the same structure as the third sub-pixel 430 and the third blocking portions 460 may be repeated in the third region 403.

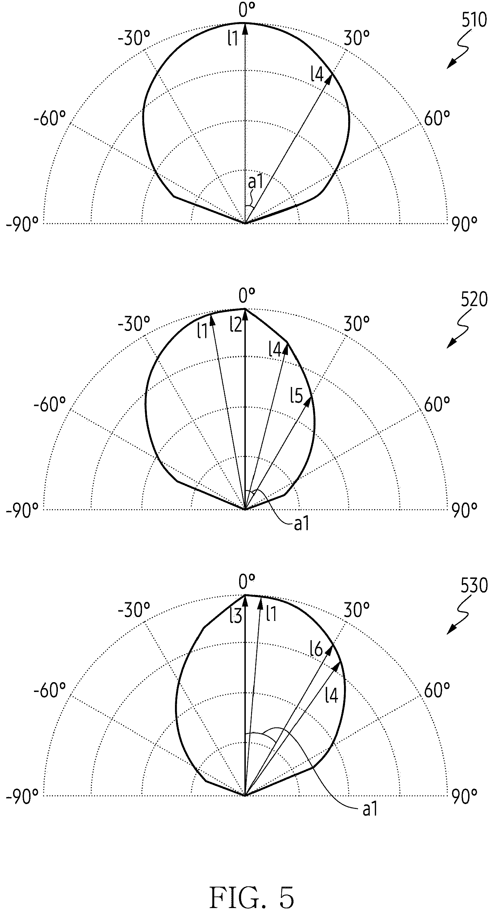

FIG. 5 is a graph indicating a relationship between a luminance and an angle of each of an exemplary plurality of sub-pixels according to an embodiment.

In FIG. 5, a graph 510 indicates a relationship between a luminance and an angle of a first sub-pixel (e.g., the first sub-pixel 410 of FIG. 4B), a graph 520 indicates a relationship between a luminance and an angle of a second sub-pixel (e.g., the second sub-pixel 420 of FIG. 4B), and a graph 530 indicates a relationship between a luminance and an angle of a third sub-pixel (e.g., the third sub-pixel 430 of FIG. 4B). According to an embodiment, the luminance of the graphs 510, 520, and 530 of FIG. 5 may mean a luminance measured outside a light blocking layer (e.g., the light blocking layer 406 of FIG. 4B).

Referring to FIG. 5, the luminance according to the angle of the first sub-pixel 410 may be symmetrical with respect to a first direction 11 in which the first sub-pixel 410 faces. According to an embodiment, a luminance of light emitted through the light blocking layer 406 along the first direction 11 in which the first sub-pixel 410 faces may be greater than a luminance of light emitted from the first sub-pixel 410 through the light blocking layer 406 along a fourth direction l4 rotated by a specified angle a1 relative to the first direction 11. The fourth direction l4 may mean a direction rotated from the first direction 11 by the specified angle a1 along a direction approaching a folding axis (e.g., the folding axis f of FIG. 4B) relative to the first direction l1. The fourth direction l4 may mean a direction rotated from the first direction 11 by the specified angle a1 along a clockwise direction relative to the first direction 11. The specified angle a1 may be, for example, approximately 30 degrees, but is not limited thereto.

According to an embodiment, the luminance according to the angle of the second sub-pixel 420 may be asymmetric with respect to a second direction l2 in which the second sub-pixel 420 faces by second blocking portions (e.g., the second blocking portions 450 of FIG. 4B). An angle between the second direction l2 and the first direction l1 may correspond to an angle between a first region (e.g., the first region 401 of FIG. 4A and FIG. 4B) and a second region (e.g., the second region 402 of FIG. 4A and FIG. 4B). According to an embodiment, a luminance of light emitted along the second direction l2 in which the second sub-pixel 420 faces may be greater than a luminance of light emitted from the second sub-pixel 420 through the light blocking layer 406 along a fifth direction l5 rotated by the specified angle a1 relative to the second direction l2. The fifth direction l5 may mean a direction rotated from the second direction l2 by the specified angle a1 along a direction approaching the folding axis f relative to the second direction l2. The fifth direction l5 may mean a direction rotated from the second direction l2 by the specified angle a1 along the clockwise direction relative to the second direction l2.

According to an embodiment, a difference between the luminance of the light emitted from the first sub-pixel 410 along the first direction l1 through the light blocking layer 406 and the luminance emitted from the first sub-pixel 410 through the light blocking layer 406 along the fourth direction l4 may be different from a difference between the luminance of the light emitted from the second sub-pixel 420 through the light blocking layer 406 along the second direction l2 and the luminance of the light emitted from the second sub-pixel 420 through the light blocking layer 406 along the fifth direction l5. For example, the difference between the luminance of the light emitted from the first sub-pixel 410 along the first direction l1 through the light blocking layer 406 and the luminance emitted from the first sub-pixel 410 along the fourth direction l4 may be smaller than the difference between the luminance of the light emitted from the second sub-pixel 420 through the light blocking layer 406 along the second direction l2 and the luminance of the light emitted from the second sub-pixel 420 through the light blocking layer 406 along the fifth direction l5. For example, since a portion of the light emitted from the second sub-pixel 420 along the fifth direction l5 is blocked by one (e.g., the one 451 of the second blocking portions 450 of FIG. 4B) of the second blocking portions 450, the luminance of the light emitted from the second sub-pixel 420 along the fifth direction l5 may be smaller than the luminance of the light emitted from the first sub-pixel 410 along the fourth direction l4.

According to an embodiment, the luminance of the light emitted from the first sub-pixel 410 through the light blocking layer 406 along the fourth direction l4 may correspond to the luminance of the light emitted from the second sub-pixel 420 through the light blocking layer 406 along the fourth direction l4. The luminance of the light emitted from the first sub-pixel 410 through the light blocking layer 406 along the fourth direction l4 and the luminance of the light emitted from the second sub-pixel 420 through the light blocking layer 406 along the fourth direction l4 may be the same by the second blocking portions 450. As the luminance of the first sub-pixel 410 in the fourth direction l4 and the luminance of the second sub-pixel 420 in the fourth direction l4 are substantially the same, a display (e.g., the display 400 of FIGS. 4A and 4B) may provide uniform visual information.

According to an embodiment, the luminance according to the angle of the third sub-pixel 430 may be asymmetric with respect to a third direction l3 in which the third sub-pixel 430 faces by third blocking portions (e.g., the third blocking portions 460 of FIG. 4B). An angle between the third direction l3 and the first direction l1 may correspond to an angle between the first region 401 and a third region (e.g., the third region 403 of FIG. 4A and FIG. 4B). According to an embodiment, a luminance of light emitted along the third direction l3 in which the third sub-pixel 430 faces may be greater than a luminance of light emitted from the third sub-pixel 430 through the light blocking layer 406 along a sixth direction l6 rotated by the specified angle a1 relative to the third direction l3. The sixth direction l6 may mean a direction rotated from the third direction l3 by the specified angle a1 along a direction approaching the folding axis f relative to the third direction l3. The sixth direction l6 may mean a direction rotated from the third direction l3 by the specified angle a1 along the clockwise direction relative to the third direction l3.

According to an embodiment, a difference between the luminance of the light emitted from the first sub-pixel 410 along the first direction l1 through the light blocking layer 406 and the luminance emitted from the first sub-pixel 410 through the light blocking layer 406 along the fourth direction l4 may be different from a difference between the luminance of the light emitted from the third sub-pixel 430 through the light blocking layer 406 along the third direction l3 and the luminance of light emitted from the third sub-pixel 430 through the light blocking layer 406 along the sixth direction l6. For example, the difference between the luminance of the light emitted from the first sub-pixel 410 along the first direction 11 through the light blocking layer 406 and the luminance emitted from the first sub-pixel 410 through the light blocking layer 406 along the fourth direction l4 may be greater than the difference between the luminance of the light emitted from the third sub-pixel 430 through the light blocking layer 406 along the third direction l3 and the luminance of light emitted from the third sub-pixel 430 through the light blocking layer 406 along the sixth direction l6. For example, since a portion of the light emitted from the third sub-pixel 430 along the sixth direction l6 is not covered by the third blocking portions 460, the luminance of the light emitted from the third sub-pixel 430 along the sixth direction l6 may be greater than the luminance of the light emitted from the first sub-pixel 410 along the fourth direction l4.

According to an embodiment, the luminance of the light emitted from the first sub-pixel 410 through the light blocking layer 406 along the fourth direction l4 may correspond to the luminance of the light emitted from the third sub-pixel 430 through the light blocking layer 406 along the fourth direction l4. The luminance of the light emitted from the first sub-pixel 410 through the light blocking layer 406 along the fourth direction l4 may be the same as the luminance of the light emitted from the third sub-pixel 430 through the light blocking layer 406 along the fourth direction l4. As the luminance of the first sub-pixel 410 in the fourth direction l4 and the luminance of the third sub-pixel 430 in the fourth direction l4 are substantially the same, the display 400 may provide the uniform visual information.

As described above, as a difference of a luminance between the first region 401, the second region 402, and the third region 403 according to an angle at which the display 400 is viewed is reduced, the display 400 according to an embodiment may provide a structure capable of providing uniform visual information.

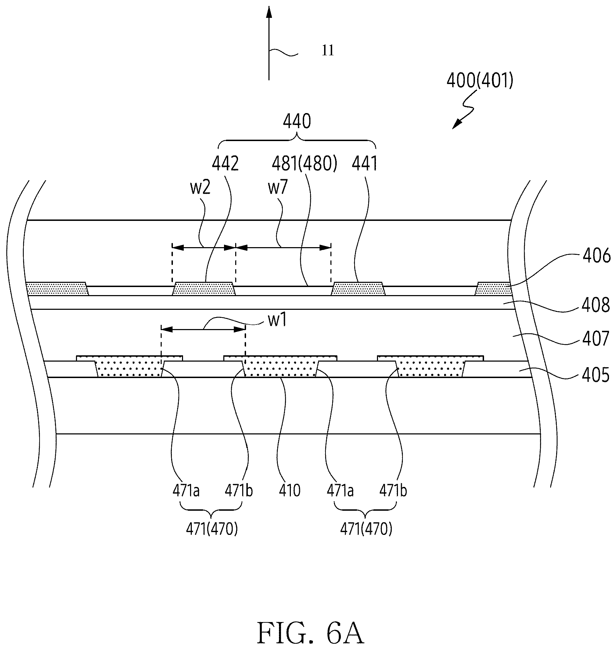

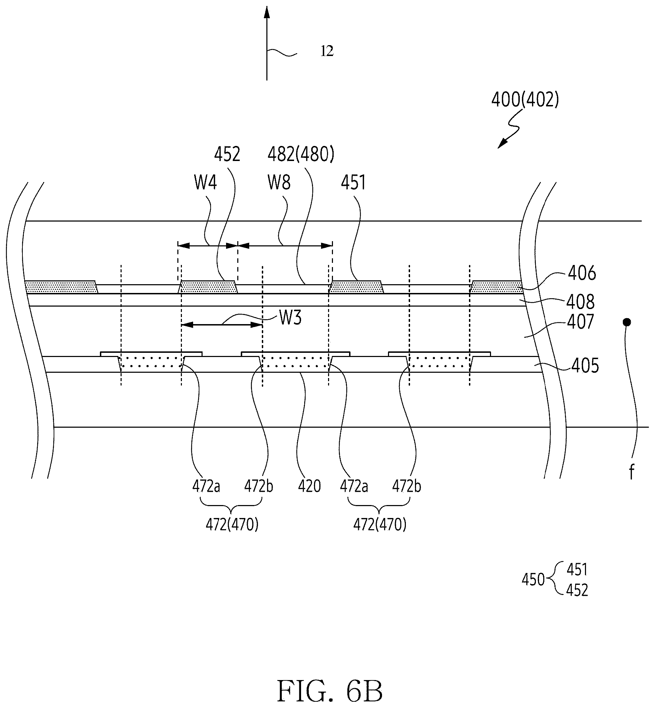

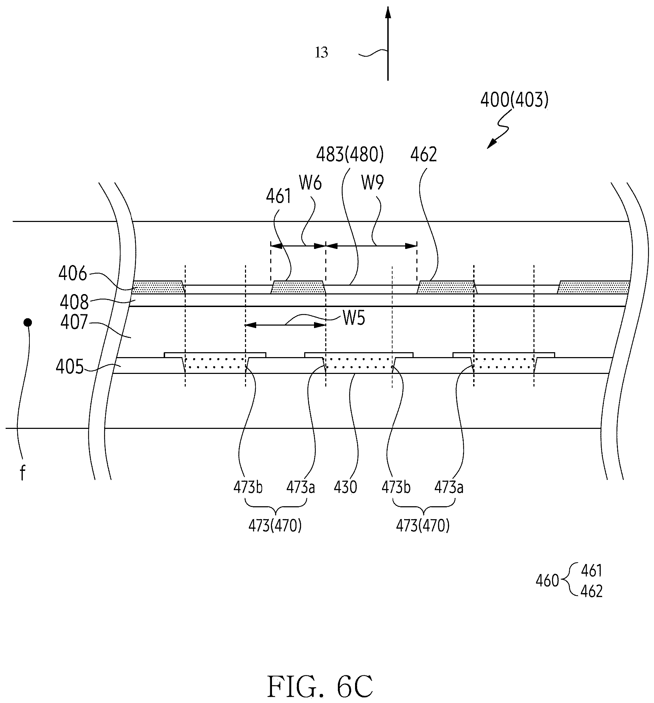

FIG. 6A is a cross-sectional view illustrating an example of cutting a first region of an exemplary display according to an embodiment, FIG. 6B is a cross-sectional view illustrating an example of cutting a second region of an exemplary display according to an embodiment, and FIG. 6C is a cross-sectional view illustrating an example of cutting a third region of an exemplary display according to an embodiment.

Referring to FIG. 6A, FIG. 6B, and FIG. 6C, a display 400 according to an embodiment may include an encapsulation layer 407 and/or an electrode layer 408.

According to an embodiment, the encapsulation layer 407 may block an inflow of a foreign substance into a plurality of sub-pixels. The encapsulation layer 407 may encapsulate the plurality of sub-pixels in the display 400. For example, the encapsulation layer 407 may encapsulate a first sub-pixel 410 in a first region 401, a second sub-pixel 420 in a second region 402, and/or a third sub-pixel 430 in a third region 403. According to an embodiment, the encapsulation layer 407 may be disposed in the first region 401, the second region 402, the third region 403, and/or a fourth region (e.g., the fourth region 404 of FIG. 4B). The encapsulation layer 407 may be disposed on a pixel layer 405. The encapsulation layer 407 may be interposed between the pixel layer 405 and a light blocking layer 406.

According to an embodiment, a thickness of the encapsulation layer 407 may be substantially constant in the display 400. For example, a thickness of the encapsulation layer 407 in the first region 401 may be substantially the same as a thickness of the encapsulation layer 407 in the second region 402. For example, the thickness of the encapsulation layer 407 in the first region 401 may be substantially the same as a thickness of the encapsulation layer 407 in the third region 403. However, it is not limited thereto. For example, the thickness of the encapsulation layer 407 in the first region 401 may be smaller than the thickness of the encapsulation layer 407 in the second region 402. In case that the thickness of the encapsulation layer 407 is thicker in the second region 402 than in the first region 401, a viewing angle of the second sub-pixel 420 may be narrower than a viewing angle of the first sub-pixel 410. In case that the thickness of the encapsulation layer 407 is thicker in the second region 402 than in the first region 401, a distance between the second sub-pixel 420 and second blocking portions 450 may be greater than a distance between the first sub-pixel 410 and first blocking portions 440. For example, the thickness of the encapsulation layer 407 in the first region 401 may be smaller than the thickness of the encapsulation layer 407 in the third region 403. In case that the thickness of the encapsulation layer 407 is thicker in the third region 403 than in the first region 401, a viewing angle of the third sub-pixel 430 may be narrower than a viewing angle of the first sub-pixel 410. In case that the thickness of the encapsulation layer 407 is thicker in the third region 403 than in the first region 401, a distance between the third sub-pixel 430 and third blocking portions 460 may be greater than the distance between the first sub-pixel 410 and the first blocking portions 440.

According to an embodiment, the electrode layer 408 may receive an input from the outside of the display 400. For example, the electrode layer 408 may receive a touch input from the outside of the display 400. According to an embodiment, the electrode layer 408 may include conductive patterns (not illustrated) for receiving the input from the outside. For example, the conductive patterns may be spaced apart by an insulating layer in the electrode layer 408. The display 400 may receive the touch input from the outside of the display 400 based on identifying a change in capacitance between the conductive patterns in the electrode layer 408. According to an embodiment, the electrode layer 408 may be interposed between the pixel layer 405 and the light blocking layer 406. For example, the electrode layer 408 may be disposed on the encapsulation layer 407. For example, the electrode layer 408 may be disposed between the encapsulation layer 407 and the light blocking layer 406. However, it is not limited thereto, and the electrode layer 408 may be disposed on the light blocking layer 406.

According to an embodiment, the pixel layer 405 may include pixel defining portions 470. The pixel defining portions 470 may partition sub-pixels in the pixel layer 405. The pixel defining portions 470 may reduce interference of light emitted from the sub-pixels by partitioning the sub-pixels in the pixel layer 405. According to an embodiment, the pixel defining portions 470 may include first pixel defining portions 471, second pixel defining portions 472, and/or third pixel defining portions 473.

According to an embodiment, the first pixel defining portions 471 may be disposed in the first region 401. According to an embodiment, each of the first pixel defining portions 471 may surround the first sub-pixel 410 in the first region 401. The first pixel defining portions 471 may be spaced apart from each other. For example, the first sub-pixel 410 may be disposed between the first pixel defining portions 471. According to an embodiment, a width w1 of each of the first pixel defining portions 471 may be greater than a width w2 of each of the first blocking portions 440. When the first blocking portions 440 are viewed in a direction opposite to the first direction 11 in which the first sub-pixel 410 faces, each of the first blocking portions 440 may be spaced apart from both ends 471a and 471b of each of the first pixel defining portions 471. For example, when the first blocking portions 440 are viewed in the direction opposite to the first direction l1, each of the first blocking portions 440 may be disposed between the both ends 471a and 471b of each of the first pixel defining portions 471. For example, when the first blocking portions 440 are viewed in the direction opposite to the first direction l1, each of the first blocking portions 440 may not overlap the both ends 471a and 471b of each of the first pixel defining portions 471. As each of the first blocking portions 440 does not overlap the both ends 471a and 471b of each of the first pixel defining portions 471, the first blocking portions 440 may be symmetrically disposed with respect to the first sub-pixel 410.

According to an embodiment, the second pixel defining portions 472 may be disposed in the second region 402. According to an embodiment, each of the second pixel defining portions 472 may surround the sub-pixel 420 in the second region 402. The second pixel defining portions 472 may be spaced apart from each other. For example, the second sub-pixel 420 may be disposed between the second pixel defining portions 472. According to an embodiment, a width w3 of each of the second pixel defining portions 472 may be greater than a width w4 of each of the second blocking portions 450. When the second blocking portions 450 are viewed in a direction opposite to the second direction l2 in which the second sub-pixel 420 faces, each of the second blocking portions 450 may overlap an end 472a of each of the second pixel defining portions 472 that is farthest from the folding axis f among both ends 472a and 472b of each of the second pixel defining portions 472. For example, when the second blocking portions 450 are viewed in the direction opposite to the second direction l2 in which the second sub-pixel 420 faces, a position of an end of each of the second blocking portions 450 may correspond to a position of the end 472a of each of the second pixel defining portions 472 that is farthest from the folding axis f among the both ends 472a and 472b of each of the second pixel defining portions 472. For example, when the second blocking portions 450 are viewed in the direction opposite to the second direction l2 in which the second sub-pixel 420 faces, the end of each of the second blocking portions 450 may be spaced apart from the end 472a of each of the second pixel defining portions 472 that is farthest from the folding axis f among the both ends 472a and 472b of each of the second pixel defining portions 472 by a specified distance (e.g., approximately 2 to 3 µm). For example, when the second blocking portions 450 are viewed in the direction opposite to the second direction l2, each of the second blocking portions 450 may be spaced apart from another end 472b of each of the second pixel defining portions 472 that is farthest from the folding axis f among the both ends 472a and 472b of each of the second pixel defining portions 472. For example, when the second blocking portions 450 are viewed in the direction opposite to the second direction l2, each of the second blocking portions 450 may not overlap the other end 472b of each of the second pixel defining portions 472 that is farthest from the folding axis f among the both ends 472a and 472b of each of the second pixel defining portions 472. As each of the second blocking portions 450 overlap the end 472a of each of the second pixel defining portions 472, the second blocking portions 450 may be asymmetrically disposed with respect to the second sub-pixel 420.

According to an embodiment, the third pixel defining portions 473 may be disposed in the third region 403. According to an embodiment, each of the third pixel defining portions 473 may surround the sub-pixel 430 in the third region 403. The third pixel defining portions 473 may be spaced apart from each other. For example, the third sub-pixel 430 may be disposed between the third pixel defining portions 473. According to an embodiment, a width w5 of each of the third pixel defining portions 473 may be greater than a width w6 of each of the third blocking portions 460. When the third blocking portions 460 are viewed in a direction opposite to the third direction l3 in which the third sub-pixel 430 faces, each of the third blocking portions 460 may overlap an end 473a of each of the third pixel defining portions 473 that is farthest from the folding axis f among both ends 473a and 473b of each of the third pixel defining portions 473. For example, when the third blocking portions 460 are viewed in the direction opposite to the third direction l3 in which the third sub-pixel 430 faces, a position of an end of each of the third blocking portions 460 may correspond to the end 473a of each of the third pixel defining portions 473 that is farthest from the folding axis f among the both ends 473a and 473b of each of the third pixel defining portions 473, but is not limited thereto. For example, when the third blocking portions 460 are viewed in the direction opposite to the third direction l3, the end of each of the third blocking portions 460 may be spaced apart from the end 473a of each of the third pixel defining portions 473 that is farthest from the folding axis f among the both ends 473a and 473b of each of the third pixel defining portions 473 by the specified distance (e.g., approximately 2 to 3 µm). For example, when the third blocking portions 460 are viewed in the direction opposite to the third direction l3, each of the third blocking portions 460 may be spaced apart from another end 473b of each of the third pixel defining portions 473 that is farthest from the folding axis f among the both ends 473a and 473b of each of the third pixel defining portions 473. For example, when the third blocking portions 460 are viewed in the direction opposite to the third direction l3, each of the third blocking portions 460 may not overlap from the other end 473b of each of the third pixel defining portions 473 that is farthest from the folding axis f among the both ends 473a and 473b of each of the third pixel defining portions 473. As each of the third blocking portions 460 overlap the end 473a of each of the third pixel defining portions 473, the third blocking portions 460 may be asymmetrically disposed with respect to the third sub-pixel 430.

According to an embodiment, the width w2 of each of the first blocking portions 440 may be different from the width w4 of each of the second blocking portions 450. For example, the width w2 of each of the first blocking portions 440 may be greater than the width w4 of each of the second blocking portions 450. As the width w2 of each of the first blocking portions 440 and the width w4 of each of the second blocking portions 450 are different, the second blocking portions 450 may be asymmetrically disposed with respect to the second sub-pixel 420.

According to an embodiment, a distance between the second blocking portions 450 may be different from a distance between the first blocking portions 440. The distance between the second blocking portions 450 may be greater than the distance between the first blocking portions 440. For example, a distance between one 451 and another 452 of the second blocking portions 450 may be greater than a distance between one 441 and another 442 of the first blocking portions 440. As the distance between the second blocking portions 450 and the distance between the first blocking portions 440 are different, they may be asymmetrically disposed with respect to the second sub-pixel 420.

According to an embodiment, the width w2 of each of the first blocking portions 440 may be different from the width w6 of each of the third blocking portions 460. For example, the width w2 of each of the first blocking portions 440 may be greater than the width w6 of each of the third blocking portions 460. As the width w2 of each of the first blocking portions 440 and the width w6 of each of the third blocking portions 460 are different, the third blocking portions 460 may be asymmetrically disposed with respect to the third sub-pixel 430.

According to an embodiment, a distance between the third blocking portions 460 may be different from the distance between the first blocking portions 440. The distance between the third blocking portions 460 may be greater than the distance between the first blocking portions 440. For example, a distance between one 461 and another 462 of the third blocking portions 460 may be greater than the distance between the one 441 and the other 442 of the first blocking portions 440. As the distance between the third blocking portions 460 and the distance between the first blocking portions 440 are different, they may be asymmetrically disposed with respect to the third sub-pixel 430.

According to an embodiment, the light blocking layer 406 may include color filter portions 480. The color filter portions 480 may increase clarity of light emitted from sub-pixels by emitting only a specified color to the outside. The color filter portions 480 may pass light corresponding to a color of light emitted from each of sub-pixels of the pixel layer 405. The number of the color filter portions 480 may correspond to the number of the sub-pixels in the pixel layer 405. According to an embodiment, the color filter portions 480 may include a first color filter portion 481, a second color filter portion 482, and/or a third color filter portion 483.

According to an embodiment, the first color filter portion 481 may pass light corresponding to a color of light emitted from the first sub-pixel 410. The first color filter portion 481 may filter light that does not correspond to the color of the light emitted from the first sub-pixel 410. For example, in case that the first sub-pixel 410 emits red light, the first color filter portion 481 may filter light of another color other than the red light. According to an embodiment, the first color filter portion 481 may be disposed on the first sub-pixel 410. For example, the first color filter portion 481 may be disposed above the first sub-pixel 410. For example, the first color filter portion 481 may be disposed between the first blocking portions 440. According to an embodiment, a width w7 of the first color filter portion 481 may correspond to the distance between the first blocking portions 440. For example, the width w7 of the first color filter portion 481 may correspond to the distance between the one 441 and the other 442 of the first blocking portions 440.

According to an embodiment, the second color filter portion 482 may pass light corresponding to a color of light emitted from the second sub-pixel 420. The second color filter portion 482 may filter light that does not correspond to the color of the light emitted from the second sub-pixel 420. For example, in case that the second sub-pixel 420 emits green light, the second color filter portion 482 may filter light of another color other than the green light. According to an embodiment, the second color filter portion 482 may be disposed on the second sub-pixel 420. For example, the second color filter portion 482 may be disposed above the second sub-pixel 420. For example, the second color filter portion 482 may be disposed between the second blocking portions 450. According to an embodiment, a width w8 of the second color filter portion 482 may correspond to the distance between the second blocking portions 450. For example, the width w8 of the second color filter portion 482 may correspond to the distance between the one 451 and the other 452 of the second blocking portions 450. According to an embodiment, the width w8 of the second color filter portion 482 may be different from the width w7 of the first color filter portion 481. For example, as the distance between the second blocking portions 450 is greater than the distance between the first blocking portions 440, the width w8 of the second color filter portion 482 may be greater than the width w7 of the first color filter portion 481.

According to an embodiment, the third color filter portion 483 may pass light corresponding to a color of light emitted from the third sub-pixel 430. The third color filter portion 483 may filter light that does not correspond to the color of the light emitted from the third sub-pixel 430. For example, when the third sub-pixel 430 emits blue light, the third color filter portion 483 may filter light of another color other than the blue light. According to an embodiment, the third color filter portion 483 may be disposed on the third sub-pixel 430. For example, the third color filter portion 483 may be disposed above the third sub-pixel 430. For example, the third color filter portion 483 may be disposed between the third blocking portions 460. According to an embodiment, a width w9 of the third color filter portion 483 may correspond to the distance between the third blocking portions 460. For example, the width w9 of the third color filter portion 483 may correspond to the distance between the one 461 and the other 462 of the third blocking portions 461. According to an embodiment, the width w9 of the third color filter portion 483 may be different from the width w7 of the first color filter portion 481. For example, as the distance between the third blocking portions 460 is greater than the distance between the first blocking portions 440, the width w9 of the third color filter portion 483 may be greater than the width w7 of the first color filter portion 481.

As described above, since each of the second blocking portions 450 overlap the end 472a of each of the second pixel defining portions 472, the display 400 according to an embodiment may provide a structure in which a portion of the viewing angle of the second sub-pixel 420 close to the folding axis f is reduced. Since each of the third blocking portions 460 overlap the end 473a of each of the third pixel defining portions 473, the display 400 according to an embodiment may provide a structure in which a portion of the viewing angle of the third sub-pixel 430 close to the folding axis f is reduced.

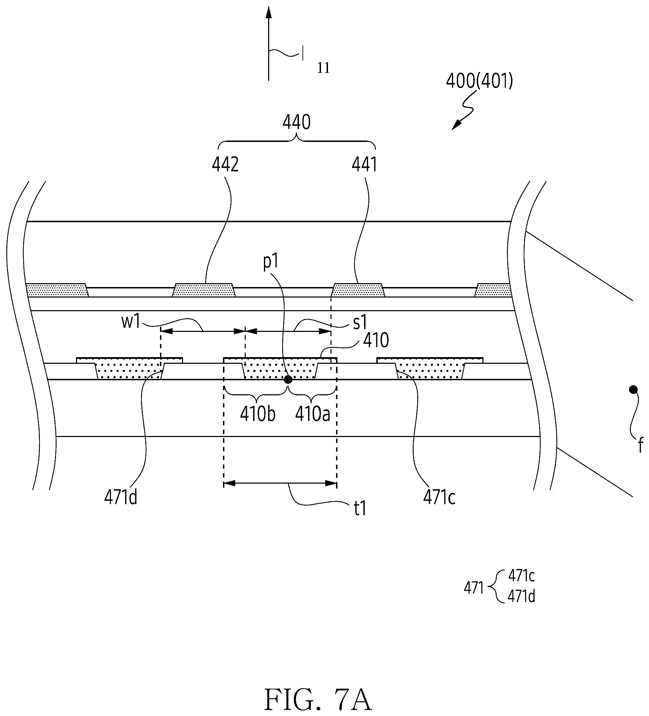

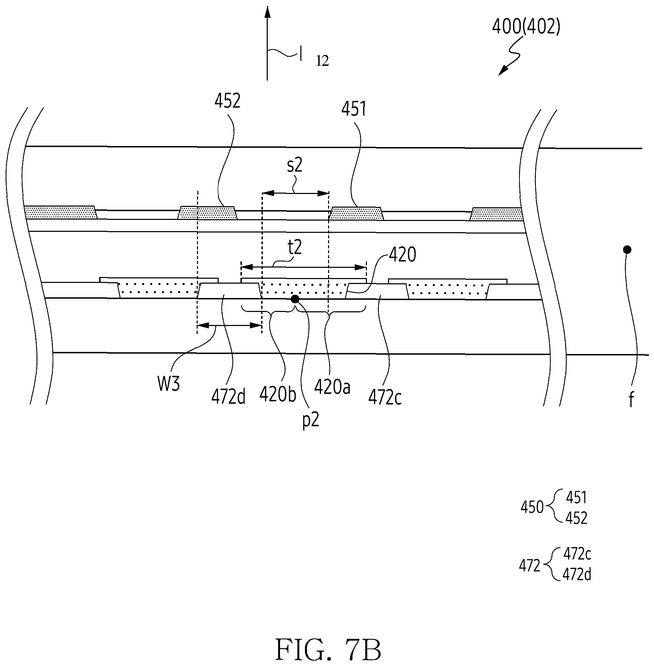

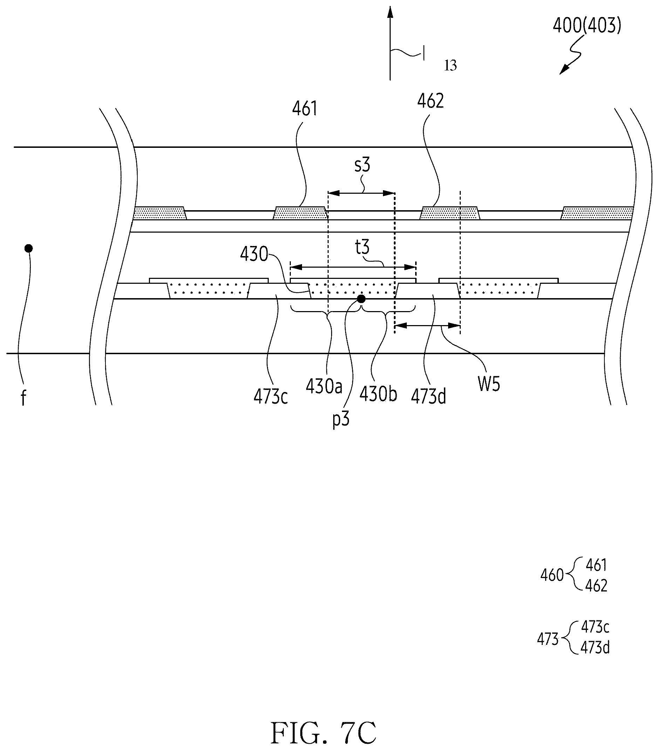

FIG. 7A is a cross-sectional view illustrating an example of cutting a first region of an exemplary display according to an embodiment, FIG. 7B is a cross-sectional view illustrating an example of cutting a second region of an exemplary display according to an embodiment, and FIG. 7C is a cross-sectional view illustrating an example of cutting a third region of an exemplary display according to an embodiment.

Referring to FIG. 7A, FIG. 7B, and FIG. 7C, according to an embodiment, a size of a first sub-pixel 410 in a first region 401 may be different from at least one of a size of a second sub-pixel 420 in a second region 402 and a size of a third sub-pixel 430 in a third region 403. For example, the size of the second sub-pixel 420 may be larger than the size of the first sub-pixel 410. For example, the size of the third sub-pixel 430 may be larger than the size of the first sub-pixel 410. According to an embodiment, a width t1 of the first sub-pixel 410 may be different from at least one of a width t2 of the second sub-pixel 420 and a width t3 of the third sub-pixel 430. For example, the width t1 of the first sub-pixel 410 may be smaller than the width t2 of the second sub-pixel 420. For example, the width t1 of the first sub-pixel 410 may be smaller than the width t3 of the third sub-pixel 430. As the size of the first sub-pixel 410 and the size of the second sub-pixel 420 are different, a viewing angle of the first sub-pixel 410 and a viewing angle of the second sub-pixel 420 may be different from each other. As the size of the first sub-pixel 410 and the size of the third sub-pixel 430 are different, the viewing angle of the first sub-pixel 410 and a viewing angle of the third sub-pixel 430 may be different from each other.

According to an embodiment, first blocking portions 440 may surround the first sub-pixel 410. For example, one 441 of the first blocking portions 440 and another 442 of the first blocking portions 440 may surround the first sub-pixel 410.

According to an embodiment, the first sub-pixel 410 in the first region 401 may be surrounded by first pixel defining portions 471. For example, the first sub-pixel 410 may be surrounded by one 471c and another 471d of the first pixel defining portions 471. A folding axis f may be close to the one 471c of the first pixel defining portions 471 among the one 471c and the other 471d of the first pixel defining portions 471.

According to an embodiment, a size of a portion 410a of the first sub-pixel 410 close to the folding axis f may be different from the size of another portion 410b of the first sub-pixel 410 that is farthest from the folding axis f with respect to a first position p1 of the sub-pixel 410 positioned at a center point of a first distance s1, which is a distance between the other 471d of the first pixel defining portions 471 and the one 441 of the first blocking portions 440. For example, with respect to the first position p1, an area of the portion 410a of the first sub-pixel 410 close to the folding axis f may be different from an area of the other portion 410b of the first sub-pixel 410 that is farthest from the folding axis f. For example, with respect to the first position p1, the area of the portion 410a of the first sub-pixel 410 close to the folding axis f may be smaller than the area of the other portion 410b of the first sub-pixel 410 that is farthest from the folding axis f. The portion 410a of the first sub-pixel 410 and the other portion 410b of the first sub-pixel 410 may be divided with respect to the first position p1. The first distance s1 may be substantially perpendicular to a first direction l1 in which the first region 401 faces. For example, a distance in a direction substantially perpendicular to the first direction 11 from the first position p1 to the other 471d of the first pixel defining portions 471 may be substantially the same as a distance in a direction substantially perpendicular to the first direction 11 from the first position p1 to the one 441 of the first blocking portions 440.

According to an embodiment, second blocking portions 450 may surround the second sub-pixel 420 in the second region 402. For example, one 451 of the second blocking portions 450 and another 452 of the second blocking portions 450 may surround the second sub-pixel 420.

According to an embodiment, the second sub-pixel 420 in the second region 402 may be surrounded by the second pixel defining portions 472. For example, the second sub-pixel 420 may be surrounded by one 472c and another 472d of the second pixel defining portions 472. The folding axis f may be close to the one 472c of the second pixel defining portions 472 among the one 472c and the other 472d of the second pixel defining portions 472. For example, a distance between the folding axis f and the one 472c of the second pixel defining portions 472 may be shorter than a distance between the folding axis f and the other 472d of the second pixel defining portions 472.

According to an embodiment, with respect to a second position p2 of the second sub-pixel 420 positioned at a center point of a second distance s2, which is a distance between the other 472d of the second pixel defining portions 472 and the one 451 of the second blocking portions 450, a size of a portion 420a of the second sub-pixel 420 close to the folding axis f and a size of another portion 420b of the second sub-pixel 420 that is farthest from the folding axis f may be different from each other. For example, with respect to the second position p2, the size of the portion 420a of the second sub-pixel 420 close to the folding axis f may be larger than the size of the other portion 420b of the second sub-pixel 420 that is farthest from the folding axis f. For example, with respect to the second position p2, an area of the portion 420a of the second sub-pixel 420 close to the folding axis f may be larger than an area of the other portion 420b of the second sub-pixel 420 that is farthest from the folding axis f. The portion 420a of the second sub-pixel 420 and the other portion 420b of the second sub-pixel 420 may be divided with respect to the second position p2. The second distance s2 may be substantially perpendicular to a second direction l2 in which the second region 402 faces. For example, a distance in a direction substantially perpendicular to the second direction l2 from the second position p2 to the other 472d of the second pixel defining portions 472 may be substantially the same as a distance in a direction substantially perpendicular to the second direction l2 from the second position p2 to the one 451 of the second blocking portions 450. According to an embodiment, a difference between the size of the portion 420a of the second sub-pixel 420 close to the folding axis f and the size of the other portion 420b of the second sub-pixel 420 that is farthest from the folding axis f, with respect to the second position p2, may be greater than a difference between the size of the portion 410a of the first sub-pixel 410 close to the folding axis f and the size of the other portion 410b of the first sub-pixel 410 that is farthest from the folding axis f, with respect to the first position p1. A difference between the area of the portion 420a of the second sub-pixel 420 close to the folding axis f and the area of the other portion 420b of the second sub-pixel 420 that is farthest from the folding axis f, with respect to the second position p2, may be greater than a difference between the area of the portion 410a of the first sub-pixel 410 close to the folding axis f and the area of the other portion 410b of the first sub-pixel 410 that is farthest from the folding axis f, with respect to the first position p1. The area of the portion 420a of the second sub-pixel 420 close to the folding axis f among the portion 420a of the second sub-pixel 420 and the other portion 420b of the second sub-pixel 420 may be larger than the area of the portion 410a of the first sub-pixel 410 close to the folding axis f among the portion 410a of the first sub-pixel 410 and the other portion 410b of the first sub-pixel 410. As the area of the portion 420a of the second sub-pixel 420 is larger than the area of the portion 410a of the first sub-pixel 410, an area of the second sub-pixel 420 covered by the one 451 of the second blocking portions 450 may be larger than an area of the first sub-pixel 410 covered by the one 441 of the first blocking portions 440. As the area of the second sub-pixel 420 covered by the one 451 of the second blocking portions 450 is greater than the area of the first sub-pixel 410 covered by the one 441 of the first blocking portions 440, a portion of the viewing angle of the second sub-pixel 420 close to the folding axis f may be reduced.

According to an embodiment, third blocking portions 460 may surround the third sub-pixel 430 in the third region 403. For example, one 461 of the third blocking portions 460 and another 462 of the third blocking portions 460 may surround the third sub-pixel 430.

According to an embodiment, the third sub-pixel 430 in the third region 403 may be surrounded by third pixel defining portions 473. For example, the third sub-pixel 430 may be surrounded by one 473c and another 473d of the third pixel defining portions 473. The folding axis f may be close to the one 473c of the third pixel defining portions 473 among the one 473c and the other 473d of the third pixel defining portions 473. For example, a distance between the folding axis f and the one 473c of the third pixel defining portions 473 may be shorter than a distance between the folding axis f and the other 473d of the third pixel defining portions 473.

According to an embodiment, with respect to a third position p3 of the third sub-pixel 430 positioned at a center point of a third distance s3, which is a distance between the other 473d of the third pixel defining portions 473 and the one 461 of the third blocking portions 460, a size of a portion 430a of the third sub-pixel 430 close to the folding axis f and a size of another portion 430b of the third sub-pixel 430 that is farthest from the folding axis f may be different from each other. For example, with respect to the third position p3, the size of the portion 430a of the third sub-pixel 430 close to the folding axis f may be larger than the size of the other portion 430b of the third sub-pixel 430 that is farthest from the folding axis f. For example, with respect to the third position p3, an area of the portion 430a of the third sub-pixel 430 close to the folding axis f may be larger than an area of the other portion 430b of the third sub-pixel 430 that is farthest from the folding axis f. The portion 430a of the third sub-pixel 430 and the other portion 430b of the third sub-pixel 430 may be divided with respect to the third position p3. The third distance s3 may be substantially perpendicular to a third direction l3 in which the third region 403 faces. For example, a distance in a direction substantially perpendicular to the third direction l3 from the third position p3 to the other 473d of the third pixel defining portions 473 may be substantially the same as a distance in a direction substantially perpendicular to the third direction l3 from the third position p3 to the one 461 of the third blocking portions 460. According to an embodiment, a difference between the size of the portion 430a of the third sub-pixel 430 close to the folding axis f and the size of the other portion 430b of the third sub-pixel 430 that is farthest from the folding axis f, with respect to the third position p3, may be greater than the difference between the size of the portion 410a of the first sub-pixel 410 close to the folding axis f and the size of the other portion 410b of the first sub-pixel 410 that is farthest from the folding axis f, with respect to the first position p1. A difference between the area of the portion 430a of the third sub-pixel 430 close to the folding axis f and the area of the other portion 430b of the third sub-pixel 430 that is farthest from the folding axis f, with respect to the third position p3, may be greater than the difference between the area of the portion 410a of the first sub-pixel 410 close to the folding axis f and the area of the other portion 410b of the first sub-pixel 410 that is farthest from the folding axis f, with respect to the first position p1. The area of the portion 430a of the third sub-pixel 430 close to the folding axis f among the portion 430a of the third sub-pixel 430 and the other portion 430b of the third sub-pixel 430 may be larger than the area of the portion 410a of the first sub-pixel 410 close to the folding axis f among the portion 410a of the first sub-pixel 410 and the other portion 410b of the first sub-pixel 410. As the area of the portion 430a of the third sub-pixel 430 is larger than the area of the portion 410a of the first sub-pixel 410, an area of the third sub-pixel 420 covered by the one 461 of the third blocking portions 460 may be larger than the area of the first sub-pixel 410 covered by the one 441 of the first blocking portions 440. As the area of the third sub-pixel 420 covered by the one 461 of the third blocking portions 460 is larger than the area of the first sub-pixel 410 covered by the one 441 of the first blocking portions 440, the viewing angle of the third sub-pixel 430 may be different from the viewing angle of the first sub-pixel 410. As an area of the third sub-pixel 430 covered by the other 462 of the third blocking portions 460 is smaller than the area of the first sub-pixel 410 covered by the other 442 of the first blocking portions 440, a portion of the viewing angle that is farthest from the folding axis f may be expanded.

According to an embodiment, a width w1 of each of the first pixel defining portions 471 may be different from a width w3 of each of the second pixel defining portions 472 and a width w5 of each of the third pixel defining portions 473. For example, the width w3 of each of the second pixel defining portions 472 may be smaller than the width w1 of each of the first pixel defining portions 471. For example, the width w5 of each of the third pixel defining portions 473 may be smaller than the width w1 of each of the first pixel defining portions 471.

As described above, since the size of the second sub-pixel 420 is larger than that of the first sub-pixel 410, the display 400 according to an embodiment may provide a structure in which the viewing angle of the first sub-pixel 410 and the viewing angle of the second sub-pixel 420 are different from each other. Since the size of the third sub-pixel 430 is larger than the size that of the first sub-pixel 410, the display 400 according to an embodiment may provide a structure in which the viewing angle of the first sub-pixel 410 and the viewing angle of the third sub-pixel 430 are different from each other.

A display of an electronic device may include sub-pixels that emit light to provide visual information to a user. As the display is foldable, a portion of the display may be curved relative to another portion of the display. As the display has a curvature, a luminance of light emitted from sub-pixels disposed in the portion of the display and light emitted from sub-pixels disposed in the other portion of the display may be changed according to an angle at which the user views the display. In case that the luminance of the light from the portion of the display and the luminance of the light from the other portion of the display are different from each other, the user may feel uncomfortable. The electronic device may require the display capable of providing uniform visual information despite the angle at which the user views.

The technical problems to be achieved in this document are not limited to those described above, and other technical problems not mentioned herein will be clearly understood by those having ordinary knowledge in the art to which this document belongs, from the following description.

According to an embodiment, a display (e.g., the display 400 of FIG. 4A and FIG. 4B) may comprise a planar first region (e.g., the first region 401 of FIG. 4A and FIG. 4B). According to an embodiment, the display may comprise a second region (e.g., the second region 402 of FIG. 4A and FIG. 4B), connected to the first region, disposed along a folding axis of the display so as to have a slope relative to the first region. According to an embodiment, the display may comprise a pixel layer (e.g., the pixel layer 405 of FIG. 4B) including a first sub-pixel (e.g., the first sub-pixel 410 of FIG. 4B) disposed in the first region and a second sub-pixel (e.g., the second sub-pixel 420 of FIG. 4B) disposed in the second region. According to an embodiment, the display may comprise a light blocking layer (e.g., the light blocking layer 406 of FIG. 4B) disposed on the pixel layer, wherein the light blocking layer includes first blocking portions (e.g., the first blocking portions 440 of FIG. 4B) disposed on the first sub-pixel and spaced apart from each other, and second blocking portions (e.g., the second blocking portions 450 of FIG. 4B) disposed on the second sub-pixel and spaced apart from each other. According to an embodiment, in the display, an area of the first sub-pixel covered by one (e.g., the one 441 of the first blocking portions 440 of FIG. 4B) of the first blocking portions may correspond to an area of the first sub-pixel covered by another (e.g., the other 442 of the first blocking portions 440 of FIG. 4B) of the first blocking portions. According to an embodiment, in the display, an area of the second sub-pixel covered by one (e.g., the one 451 of the second blocking portions 450 of FIG. 4B) of the second blocking portions may be different from an area of the second sub-pixel covered by another (e.g., the other 452 of the second blocking portions 450 of FIG. 4B) of the second blocking portions.

Since the second blocking portions are asymmetrically disposed with respect to the second sub-pixel and the first blocking portions are symmetrically disposed with respect to the first sub-pixel, the display according to an embodiment may provide uniform visual information despite an angle at which the display is viewed.

According to an embodiment, when the second sub-pixel is viewed in a direction opposite to a direction (e.g., the second direction l2 of FIG. 4B) perpendicular to the second sub-pixel, the one of the second blocking portions may be spaced apart from the second sub-pixel, and the other of the second blocking portions may overlap a portion of the second sub-pixel. According to an embodiment, a distance between the folding axis and the one of the second blocking portions may be shorter than a distance between the folding axis and the other of the second blocking portions.

Since the one of the second blocking portions close to the folding axis overlaps the portion of the second sub-pixel, the display according to an embodiment may provide a structure in which a viewing angle of the second sub-pixel and a viewing angle of the first sub-pixel are different.

According to an embodiment, a width (e.g., the width w4 of FIG. 6B) of each of the second blocking portions may be smaller than a width (e.g., the width w2 of FIG. 6A) of each of the first blocking portions.

Since the width of each of the second blocking portions and the width of each of the first blocking portions are different, the display according to an embodiment may provide the structure in which the viewing angle of the second sub-pixel and the viewing angle of the first sub-pixel are different.

According to an embodiment, the pixel layer may include first pixel defining portions (e.g., the first pixel defining portions 471 of FIG. 6A) that each surround the first sub-pixel. According to an embodiment, the pixel layer may include second pixel defining portions (e.g., the second pixel defining portions 472 of FIG. 6B) that each surround the second sub-pixel. According to an embodiment, when the first blocking portions are viewed in a direction opposite to a direction (e.g., the first direction l1 of FIG. 6A) in which the first sub-pixel faces, each of the first blocking portions may be spaced apart from both ends (e.g., the both ends 471a and 471b of FIG. 6A) of each of the first pixel defining portions. According to an embodiment, when the second blocking portions are viewed in a direction opposite to the direction in which the second sub-pixel faces, each of the second blocking portions may overlap an end (e.g., the end 471a of FIG. 6B) of each of the second pixel defining portions that is farthest from the folding axis from among both ends (e.g., the both ends 472a and 472b of FIG. 6B) of each of the second pixel defining portions.

Since each of the second blocking portions overlaps the end of each of the second pixel defining portions, the display according to an embodiment may provide the structure in which the viewing angle of the second sub-pixel and the viewing angle of the first sub-pixel are different.

According to an embodiment, a distance between the second blocking portions may be longer than a distance between the first blocking portions.

Since the distance between the second blocking portions and the first blocking portions are different, the display according to an embodiment may provide the structure in which the viewing angle of the second sub-pixel and the viewing angle of the first sub-pixel are different.

According to an embodiment, the display may comprise an encapsulation layer (e.g., the encapsulation layer 407 of FIG. 6A, FIG. 6B, and FIG. 6C), interposed between the pixel layer and the light blocking layer, encapsulating the first sub-pixel and the second sub-pixel.

The display according to an embodiment may provide a structure capable of reducing damage to sub-pixels by the encapsulation layer encapsulating the sub-pixels.

According to an embodiment, the light blocking layer may comprise a first color filter portion (e.g., the first color filter portion 481 of FIG. 6A) disposed between the first blocking portions. According to an embodiment, the light blocking layer may comprise a second color filter portion (e.g., the second color filter portion 482 of FIG. 6B) disposed between the second blocking portions. According to an embodiment, a width of the second color filter portion may be larger than a width of the first color filter member.

Since the width of the first color filter portion is larger than the width of the second color filter member, the display according to an embodiment may provide the structure in which the viewing angle of the second sub-pixel and the viewing angle of the first sub-pixel are different.

According to an embodiment, a difference between a luminance of light emitted from the first sub-pixel through the light-blocking layer along a first direction (e.g., the first direction l1 of FIG. 5) perpendicular to the first sub-pixel and a luminance of light emitted from the first sub-pixel through the light-blocking layer along a second direction (e.g., the fourth direction l4 of FIG. 5) rotated by a specified angle relative to the first direction may be smaller than a difference between a luminance of light emitted from the second sub-pixel through the light-blocking layer along a third direction (e.g., the second direction l2 of FIG. 5) perpendicular to the second sub-pixel and a luminance of light emitted from the second sub-pixel through the light-blocking layer along a fourth direction (e.g., the fifth direction l5 of FIG. 5) rotated by the specified angle relative to the third direction.

Since a luminance distribution according to an angle of the first sub-pixel and a luminance distribution according to an angle of the second sub-pixel are different, the display according to an embodiment may provide the uniform visual information despite the angle at which the display is viewed.

According to an embodiment, the luminance of the light emitted from the first sub-pixel through the light-blocking layer along the second direction may correspond to the luminance of the light emitted from the second sub-pixel through the light-blocking layer along the second direction.

Since the luminance of the first sub-pixel in the second direction and the luminance of the second sub-pixel in the second direction are the same, the display according to an embodiment may provide the uniform visual information independently of the angle at which the display is viewed.

According to an embodiment, the display may comprise a third region (e.g., the third region 403 of FIG. 4A and FIG. 4B), connected to the second region, disposed along the folding axis of the display so as to have a slope relative to the first region and the second region. According to an embodiment, the pixel layer may include a third sub-pixel (e.g., the third sub-pixel 430 of FIG. 4B) disposed within the third region. According to an embodiment, the light blocking layer may include third blocking portions (e.g., the third blocking portions 460 of FIG. 4B), disposed on the third sub-pixel, spaced apart from each other. According to an embodiment, an area of the third sub-pixel covered by one (e.g., the one 461 of the third blocking portions 460 of FIG. 4B) of the third blocking portions may be different from an area of the third sub-pixel covered by another (e.g., the other 462 of the third blocking portions 460 of FIG. 4B) of the third blocking portions.

Since the third blocking portions are asymmetrically disposed with respect to the third sub-pixel and the first blocking portions are symmetrically disposed with respect to the first sub-pixel, the display according to an embodiment may provide the uniform visual information despite the angle at which the display is viewed.

According to an embodiment, when the third sub-pixel is viewed in a direction opposite to a direction (e.g., the third direction l3 of FIG. 4B) perpendicular to the third sub-pixel, the one of the third blocking portions overlaps a portion of the third sub-pixel, the another of the third blocking portions may be spaced apart from the third sub-pixel. According to an embodiment, a distance between the folding axis and the one of the third blocking portions may be shorter than a distance between the folding axis and the another of the third blocking portions.

Since the one of the third blocking portions close to the folding axis overlaps the third sub-pixel, the display according to an embodiment may provide a structure capable of blocking a portion of a viewing angle of the third sub-pixel close to the folding axis.

According to an embodiment, the folding axis may be positioned between the second region and the third region.

According to an embodiment, the pixel layer may include third pixel defining portions (e.g., the third pixel defining portions 473 of FIG. 6C) that each surround the third sub-pixel. According to an embodiment, when the third blocking portions are viewed in a direction opposite to a direction perpendicular to the third region, each of the third blocking portions may overlap an end (e.g., the end 473a of FIG. 6C) of each of the third pixel defining portions that is farthest from the folding axis from among both ends (e.g., the both ends 473a and 473b of FIG. 6C) of each of the third pixel defining portions.

Since each of the third blocking portions overlaps the end of each of the third pixel defining portions, the display according to an embodiment may provide a structure in which the viewing angle of the third sub-pixel and the viewing angle of the first sub-pixel are different.

According to an embodiment, the light blocking layer may comprise a first color filter portion (e.g., the first color filter portion 481 of FIG. 6A) disposed between the first blocking portions. According to an embodiment, the light blocking layer may comprise a third color filter portion (e.g., the third color filter portion 482 of FIG. 6B) disposed between the third blocking portions. According to an embodiment, a width of the third color filter portion may be larger than a width of the first color filter member.

Since the width of the first color filter portion is larger than the width of the third color filter member, the display according to an embodiment may provide the structure in which the viewing angle of the third sub-pixel and the viewing angle of the first sub-pixel are different.

According to an embodiment, the display may comprise an electrode layer (e.g., the electrode layer 408 of FIG. 6A, FIG. 6B, and FIG. 6C) interposed between the pixel layer and the light blocking layer.

The display according to an embodiment may provide a structure capable of receiving an input from the outside of the display through the electrode layer.

According to an embodiment, an electronic device (e.g., the electronic device 300 of FIG. 4A) may comprise a first housing (e.g., the first housing 410 of FIG. 4A). According to an embodiment, the electronic device may comprise a second housing (e.g., the second housing 420 of FIG. 4A) rotatably coupled to the first housing. According to an embodiment, the electronic device may comprise a display (e.g., the display 400 of FIG. 4A and FIG. 4B) foldable with respect to a folding axis (e.g., the folding axis f of FIG. 4A and FIG. 4B) by movement of the second housing relative to the first housing. According to an embodiment, the display may comprise a planar first region (e.g., the first region 401 of FIG. 4A and FIG. 4B). According to an embodiment, the display may comprise a second region (e.g., the second region 402 of FIG. 4A and FIG. 4B), connected to the first region, disposed along the folding axis of the display so as to have a slope relative to the first region. According to an embodiment, the display may comprise a pixel layer (e.g., the pixel layer 405 of FIG. 4B) including a first sub-pixel (e.g., the first sub-pixel 410 of FIG. 4B) disposed in the first region and a second sub-pixel (e.g., the second sub-pixel 420 of FIG. 4B) disposed in the second region. According to an embodiment, the display may comprise a light blocking layer (e.g., the light blocking layer 406 of FIG. 4B) disposed on the pixel layer, wherein the light blocking layer includes first blocking portions (e.g., the first blocking portions 440 of FIG. 4B) disposed on the first sub-pixel and spaced apart from each other, and second blocking portions (e.g., the second blocking portions 450 of FIG. 4B) disposed on the second sub-pixel and spaced apart from each other. According to an embodiment, in the display, an area of the first sub-pixel covered by one (e.g., the one 441 of the first blocking portions 440 of FIG. 4B) of the first blocking portions may correspond to an area of the first sub-pixel covered by another (e.g., the other 442 of the first blocking portions 440 of FIG. 4B) of the first blocking portions. According to an embodiment, in the display, an area of the second sub-pixel covered by one (e.g., the one 451 of the second blocking portions 450 of FIG. 4B) of the second blocking portions may be different from an area of the second sub-pixel covered by another (e.g., the other 452 of the second blocking portions 450 of FIG. 4B) of the second blocking portions.

According to an embodiment, when the second sub-pixel is viewed in a direction opposite to a direction (e.g., the second direction l2 of FIG. 4B) in which the second sub-pixel faces, the one of the second blocking portions may be spaced apart from the second sub-pixel, and the other of the second blocking portions may overlap a portion of the second sub-pixel.

Since the one of the second blocking portions close to the folding axis overlaps the portion of the second sub-pixel, the display according to an embodiment may provide a structure in which a viewing angle of the second sub-pixel and a viewing angle of the first sub-pixel are different.

According to an embodiment, a width (e.g., the width w4 in FIG. 6B) of each of the second blocking portions may be smaller than a width (e.g., the width w2 in FIG. 6A) of each of the first blocking portions.

Since the width of each of the second blocking portions and the width of each of the first blocking portions are different, the display according to an embodiment may provide the structure in which the viewing angle of the second sub-pixel and the viewing angle of the first sub-pixel are different.

According to an embodiment, the pixel layer may include first pixel defining portions (e.g., the first pixel defining portions 471 of FIG. 6A) that each surround the first sub-pixel. According to an embodiment, the pixel layer may include second pixel defining portions (e.g., the second pixel defining portions 472 of FIG. 6B) that each surround the second sub-pixel. According to an embodiment, when the first blocking portions are viewed in a direction opposite to a direction (e.g., the first direction l1 of FIG. 6A) in which the first sub-pixel faces, each of the first blocking portions may be spaced apart from both ends (e.g., the both ends 471a and 471b of FIG. 6A) of each of the first pixel defining portions. According to an embodiment, when the second blocking portions are viewed in a direction opposite to the direction in which the second sub-pixel faces, each of the second blocking portions may overlap an end (e.g., the end 471a of FIG. 6B) of each of the second pixel defining portions that is farthest from the folding axis from among both ends (e.g., the both ends 472a and 472b of FIG. 6B) of each of the second pixel defining portions.

Since each of the second blocking portions overlaps the end of each of the second pixel defining portions, the display according to an embodiment may provide the structure in which the viewing angle of the second sub-pixel and the viewing angle of the first sub-pixel are different.

According to an embodiment, a distance between the second blocking portions may be longer than a distance between the first blocking portions.

Since the distance between the second blocking portions and the first blocking portions are different, the display according to an embodiment may provide the structure in which the viewing angle of the second sub-pixel and the viewing angle of the first sub-pixel are different.

The effects that can be obtained from the present disclosure are not limited to those described above, and any other effects not mentioned herein will be clearly understood by those having ordinary knowledge in the art to which the present disclosure belongs, from the following description.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

As used in connection with various embodiments of the disclosure which are not part of the claimed invention, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments which are not part of the claimed invention as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment which is not part of the claimed invention, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments which are not part of the claimed invention, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. A display (400) configured to be folded with respect to a folding axis (f), the display comprising:
a planar first region (401);
a second region (402), connected to the first region (401), disposed along the folding axis (f) of the display (400) so as to have an incline with respect to the first region (401);
a pixel layer (405) including a first sub-pixel (410) disposed in the first region (401) and a second sub-pixel (420) disposed in the second region (402); and
a light blocking layer (406) disposed above the pixel layer (405), wherein the light blocking layer (406) includes first blocking portions (440) disposed above the first sub-pixel (410) and spaced apart from each other, and second blocking portions (450) disposed above the second sub-pixel (420) and spaced apart from each other,
wherein an area of the first sub-pixel (410) covered by one (441) of the first blocking portions (440) corresponds to an area of the first sub-pixel (410) covered by another (442) of the first blocking portions (440), **characterized in that**
an area of the second sub-pixel (420) covered by one (451) of the second blocking portions (450) is different from an area of the second sub-pixel (420) covered by another (452) of the second blocking portions (450).

2. The display (400) of claim 1,
wherein the first light blocking portions (440) and the second light blocking portions (450) are formed as a black matrix.

3. The display (400) of claim 1 or claim 2,
wherein the area of the first sub-pixel (410) covered by the one (441) of the first blocking portions (440) is substantially the same as the area of the first sub-pixel (410) covered by the another (442) of the first blocking portions (440).

4. The display (400) of claim 1,
wherein the area of the second sub-pixel (420) covered by the one (451) of the second blocking portions (450) is an area where the one (451) of the second blocking portions (450) overlaps the second sub-pixel (420), when viewed in a direction (v1) opposite to a direction (12) in which the second sub-pixel (420) faces, and
wherein the area of the second sub-pixel (420) covered by the another (452) of the second blocking portions (450) is an area where the another (452) of the second blocking portions (450) does not overlap the second sub-pixel (420), when viewed in the direction (v1) opposite to the direction (12) in which the second sub-pixel (420) faces.

5. The display (400) of any one of claims 1 to 4, comprising a plastically deformed portion such that the second region (402) has the incline relative to the first region (401).

6. The display (400) of any one of claims 1 to 5,
wherein, when the second sub-pixel (420) is viewed in a direction opposite to a direction (l2) in which the second sub-pixel (420) faces, the one (451) of the second blocking portions (450) overlaps a portion of the second sub-pixel (420), the another (452) of the second blocking portions (450) is spaced apart from the second sub-pixel (420), and
wherein a distance between the folding axis (f) and the one (451) of the second blocking portions (450) is shorter than a distance between the folding axis (f) and the another (452) of the second blocking portions (450).

7. The display (400) of any one of claims 1 to 6,
wherein a width (w4) of each of the second blocking portions (450) is smaller than a width (w2) of each of the first blocking portions (440).

8. The display (400) of any one of claims 1 to 7,
wherein the pixel layer (405) further includes:
first pixel defining portions (471) that each surround the first sub-pixel (410); and
second pixel defining portions (472) that each surround the second sub-pixel (420),
wherein, when the first blocking portions (440) are viewed in a direction opposite to a direction (l1) in which the first sub-pixel (410) faces, each of the first blocking portions (440) is spaced apart from both ends (471a, 471b) of each of the first pixel defining portions (471), and
wherein, when the second blocking portions (450) are viewed in a direction opposite to the direction (l2) in which the second sub-pixel (420) faces, each of the second blocking portions (450) overlaps an end (472a) of each of the second pixel defining portions (472) that is farthest from the folding axis (f) from among both ends (472a, 472b) of each of the second pixel defining portions (472).

9. The display (400) of any one of claims 1 to 8,
wherein a distance between the second blocking portions (450) is different from a distance between the first blocking portions (440).

10. The display (400) of any one of claims 1 to 9, further comprising an encapsulation layer (407), disposed between the pixel layer (405) and the light blocking layer (406), encapsulating the first sub-pixel (410) and the second sub-pixel (420),
wherein a thickness of a portion of the encapsulation layer (407) disposed in the first region (401) is equal to or smaller than a thickness of another portion of the encapsulation layer (407) disposed in the second region (402).

11. The display (400) of any one of claims 1 to 10,
wherein the light blocking layer (406) comprises:
a first color filter member (481) disposed between the first blocking portions (440); and
a second color filter member (482) disposed between the second blocking portions (450),
wherein a width of the second color filter member (482) is larger than a width of the first color filter member (481).

12. The display (400) of any one of claims 1 to 11, further comprising:
a third region (403), connected to the second region (402), disposed along the folding axis (f) of the display (400) so as to have an incline with respect to the first region (401) and the second region (402),
wherein the pixel layer (405) further includes a third sub-pixel (430) disposed within the third region (403),
wherein the light blocking layer (406) further includes third blocking portions (460), disposed above the third sub-pixel (430), spaced apart from each other, and
wherein an area of the third sub-pixel (430) covered by one (461) of the third blocking portions (460) is different from an area of the third sub-pixel (430) covered by another (462) of the third blocking portions (460).

13. The display (400) of any one of claims 1 to 12,
wherein, when the third sub-pixel (430) is viewed in a direction opposite to a direction (l3) in which the third sub-pixel (430) faces, the one (461) of the third blocking portions (460) overlaps a portion of the third sub-pixel (430), the another (462) of the third blocking portions (460) is spaced apart from the third sub-pixel (430), and
wherein a distance between the folding axis (f) and the one (461) of the third blocking portions (460) is shorter than a distance between the folding axis (f) and the another (462) of the third blocking portions (460).

14. The display (400) of any one of claims 1 to 13,
wherein a size of the second sub-pixel (420) is larger than a size of the first sub-pixel (410).

15. An electronic device comprising the display (400) of any one of claims 1 to 14.

## Patentansprüche

1. Anzeige (400), die dazu konfiguriert ist, in Bezug auf eine Faltachse (f) gefaltet zu werden, wobei die Anzeige Folgendes umfasst:
einen ebenen ersten Bereich (401);
einen zweiten Bereich (402), der mit dem ersten Bereich (401) verbunden ist und der entlang der Faltachse (f) der Anzeige (400) angeordnet ist, um eine Neigung in Bezug auf den ersten Bereich (401) aufzuweisen;
eine Pixelschicht (405), die ein erstes Subpixel (410), das in dem ersten Bereich (401) angeordnet ist, und ein zweites Subpixel (420), das in dem zweiten Bereich (402) angeordnet ist, beinhaltet; und
eine Lichtblockierschicht (406), die über der Pixelschicht (405) angeordnet ist, wobei die Lichtblockierschicht (406) erste Blockierabschnitte (440), die über dem ersten Subpixel (410) angeordnet und voneinander beabstandet sind, und zweite Blockierabschnitte (450), die über dem zweiten Subpixel (420) angeordnet und voneinander beabstandet sind, beinhaltet,
wobei eine Fläche des ersten Subpixels (410), die durch einen (441) von den ersten Blockierabschnitten (440) bedeckt ist, einer Fläche des ersten Subpixels (410) entspricht, die durch einen anderen (442) von den ersten Blockierabschnitten (440) bedeckt ist,
**dadurch gekennzeichnet, dass** sich eine Fläche des zweiten Subpixels (420), die durch einen (451) von den zweiten Blockierabschnitten (450) bedeckt ist, von einer Fläche des zweiten Subpixels (420), die durch einen anderen (452) von den zweiten Blockierabschnitten (450) bedeckt ist, unterscheidet.

2. Anzeige (400) nach Anspruch 1,
wobei die ersten Lichtblockierabschnitte (440) und die zweiten Lichtblockierabschnitte (450) als eine schwarze Matrix gebildet sind.

3. Anzeige (400) nach Anspruch 1 oder Anspruch 2,
wobei die Fläche des ersten Subpixels (410), die durch den einen (441) von den ersten Blockierabschnitten (440) bedeckt ist, im Wesentlichen die gleiche wie die Fläche des ersten Subpixels (410) ist, die durch den anderen (442) von den ersten Blockierabschnitten (440) bedeckt ist.

4. Anzeige (400) nach Anspruch 1,
wobei die Fläche des zweiten Subpixels (420), die durch den einen (451) von den zweiten Blockierabschnitten (450) bedeckt ist, eine Fläche ist, in welcher der eine (451) von den zweiten Blockierabschnitten (450) das zweite Subpixel (420) überlappt, wenn in einer Richtung (v1) entgegengesetzt zu einer Richtung (12), in die das zweite Subpixel (420) weist, betrachtet, und
wobei die Fläche des zweiten Subpixels (420), die durch den anderen (452) von den zweiten Blockierabschnitten (450) bedeckt ist, eine Fläche ist, in welcher der andere (452) von den zweiten Blockierabschnitten (450) das zweite Subpixel (420) nicht überlappt, wenn in der Richtung (v1) entgegengesetzt zu der Richtung (12), in die das zweite Subpixel (420) weist, betrachtet.

5. Anzeige (400) nach einem der Ansprüche 1 bis 4, umfassend einen plastisch verformten Abschnitt, sodass der zweite Bereich (402) die Neigung relativ zu dem ersten Bereich (401) aufweist.

6. Anzeige (400) nach einem der Ansprüche 1 bis 5,
wobei, wenn das zweite Subpixel (420) in einer Richtung entgegengesetzt zu einer Richtung (l2), in die das zweite Subpixel (420) weist, betrachtet wird, der eine (451) von den zweiten Blockierabschnitten (450) einen Abschnitt des zweiten Subpixels (420) überlappt, der andere (452) von den zweiten Blockierabschnitten (450) von dem zweiten Subpixel (420) beabstandet ist, und
wobei ein Abstand zwischen der Faltachse (f) und dem einen (451) von den zweiten Blockierabschnitten (450) kürzer als ein Abstand zwischen der Faltachse (f) und dem anderen (452) von den zweiten Blockierabschnitten (450) ist.

7. Anzeige (400) nach einem der Ansprüche 1 bis 6,
wobei eine Breite (w4) von jedem von den zweiten Blockierabschnitten (450) kleiner als eine Breite (w2) von jedem von den ersten Blockierabschnitten (440) ist.

8. Anzeige (400) nach einem der Ansprüche 1 bis 7,
wobei die Pixelschicht (405) ferner Folgendes beinhaltet:
erste pixeldefinierende Abschnitte (471), die jeweils das erste Subpixel (410) umgeben; und
zweite pixeldefinierende Abschnitte (472), die jeweils das zweite Subpixel (420) umgeben,
wobei, wenn die ersten Blockierabschnitte (440) in einer Richtung entgegengesetzt zu einer Richtung (l1), in die das erste Subpixel (410) weist, betrachtet werden, jeder von den ersten Blockierabschnitten (440) von beiden Enden (471a, 471b) von jedem von den ersten pixeldefinierenden Abschnitten (471) beabstandet ist, und
wobei, wenn die zweiten Blockierabschnitte (450) in einer Richtung entgegengesetzt zu der Richtung (l2), in die das zweite Subpixel (420) weist, betrachtet werden, jeder von den zweiten Blockierabschnitten (450) ein Ende (472a) von jedem von den zweiten pixeldefinierenden Abschnitten (472) überlappt, das am weitesten von der Faltachse (f) unter beiden Enden (472a, 472b) von jedem von den zweiten pixeldefinierenden Abschnitten (472) ist.

9. Anzeige (400) nach einem der Ansprüche 1 bis 8,
wobei sich ein Abstand zwischen den zweiten Blockierabschnitten (450) von einem Abstand zwischen den ersten Blockierabschnitten (440) unterscheidet.

10. Anzeige (400) nach einem der Ansprüche 1 bis 9, ferner umfassend eine Verkapselungsschicht (407), die zwischen der Pixelschicht (405) und der Lichtblockierschicht (406) angeordnet ist und das erste Subpixel (410) und das zweite Subpixel (420) verkapselt,
wobei eine Dicke eines Abschnittes der Verkapselungsschicht (407), der in dem ersten Bereich (401) angeordnet ist, gleich einer oder kleiner als eine Dicke eines anderen Abschnittes der Verkapselungsschicht (407) ist, der in dem zweiten Bereich (402) angeordnet ist.

11. Anzeige (400) nach einem der Ansprüche 1 bis 10,
wobei die Lichtblockierschicht (406) Folgendes umfasst:
ein erstes Farbfilterelement (481), das zwischen den ersten Blockierabschnitten (440) angeordnet ist; und
ein zweites Farbfilterelement (482), das zwischen den zweiten Blockierabschnitten (450) angeordnet ist,
wobei eine Breite des zweiten Farbfilterelements (482) größer als eine Breite des ersten Farbfilterelements (481) ist.

12. Anzeige (400) nach einem der Ansprüche 1 bis 11, ferner umfassend:
einen dritten Bereich (403), der mit dem zweiten Bereich (402) verbunden ist und der entlang der Faltachse (f) der Anzeige (400) angeordnet ist, um eine Neigung in Bezug auf den ersten Bereich (401) und den zweiten Bereich (402) aufzuweisen,
wobei die Pixelschicht (405) ferner ein drittes Subpixel (430) beinhaltet, das innerhalb des dritten Bereichs (403) angeordnet ist,
wobei die Lichtblockierschicht (406) ferner dritte Blockierabschnitte (460) beinhaltet, die über dem dritten Subpixel (430) angeordnet und voneinander beabstandet sind, und
wobei sich eine Fläche des dritten Subpixels (430), die durch einen (461) von den dritten Blockierabschnitten (460) bedeckt ist, von einer Fläche des dritten Subpixels (430), die durch einen anderen (462) von den dritten Blockierabschnitten (460) bedeckt ist, unterscheidet.

13. Anzeige (400) nach einem der Ansprüche 1 bis 12,
wobei, wenn das dritte Subpixel (430) in einer Richtung entgegengesetzt zu einer Richtung (l3), in die das dritte Subpixel (430) weist, betrachtet wird, der eine (461) von den dritten Blockierabschnitten (460) einen Abschnitt des dritten Subpixels (430) überlappt, der andere (462) von den dritten Blockierabschnitten (460) von dem dritten Subpixel (430) beabstandet ist, und
wobei ein Abstand zwischen der Faltachse (f) und dem einen (461) von den dritten Blockierabschnitten (460) kürzer als ein Abstand zwischen der Faltachse (f) und dem anderen (462) von den dritten Blockierabschnitten (460) ist.

14. Anzeige (400) nach einem der Ansprüche 1 bis 13,
wobei eine Größe des zweiten Subpixels (420) größer als eine Größe des ersten Subpixels (410) ist.

15. Elektronische Vorrichtung, umfassend die Anzeige (400) nach einem der Ansprüche 1 bis 14.

## Revendications

1. Afficheur (400) configuré pour être plié par rapport à un axe de pliage (f), l'afficheur comprenant :
une première région plane (401) ;
une deuxième région (402), raccordée à la première région (401), disposée le long de l'axe de pliage (f) de l'afficheur (400) de façon à posséder une inclinaison par rapport à la première région (401) ;
une couche de pixels (405) comprenant un premier sous-pixel (410) disposé dans la première région (401) et un deuxième sous-pixel (420) disposé dans la deuxième région (402) ; et
une couche de blocage de lumière (406) disposée au-dessus de la couche de pixels (405), ladite couche de blocage de lumière (406) comprenant des premières parties de blocage (440) disposées au-dessus du premier sous-pixel (410) et espacées les unes des autres, et des deuxièmes parties de blocage (450) disposées au-dessus du deuxième sous-pixel (420) et espacées les unes des autres,
une zone du premier sous-pixel (410) couverte par l'une (441) des premières parties de blocage (440) correspondant à une zone du premier sous-pixel (410) couverte par une autre (442) des premières parties de blocage (440), **caractérisé en ce que**
une zone du deuxième sous-pixel (420) couverte par l'une (451) des deuxièmes parties de blocage (450) étant différente d'une zone du deuxième sous-pixel (420) couverte par une autre (452) des deuxièmes parties de blocage (450).

2. Afficheur (400) de la revendication 1,
lesdites premières parties de blocage de lumière (440) et lesdites deuxièmes parties de blocage de lumière (450) étant formées sous la forme d'une matrice noire.

3. Afficheur (400) de la revendication 1 ou de la revendication 2,
ladite zone du premier sous-pixel (410) couverte par l'une (441) des premières parties de blocage (440) étant sensiblement la même que la zone du premier sous-pixel (410) couverte par l'autre (442) des premières parties de blocage (440).

4. Afficheur (400) de la revendication 1,
ladite zone du deuxième sous-pixel (420) couverte par l'une (451) des deuxièmes parties de blocage (450) étant une zone où l'une (451) des deuxièmes parties de blocage (450) chevauche le deuxième sous-pixel (420), lorsqu'elle est vue dans une direction (v1) opposée à une direction (12) dans laquelle le deuxième sous-pixel (420) est orienté, et
ladite zone du deuxième sous-pixel (420) couverte par l'autre (452) des deuxièmes parties de blocage (450) étant une zone où l'autre (452) des deuxièmes parties de blocage (450) ne chevauche pas le deuxième sous-pixel (420), lorsqu'elle est vue dans la direction (v1) opposée à la direction (12) dans laquelle le deuxième sous-pixel (420) est orienté.

5. Afficheur (400) de l'une quelconque des revendications 1 à 4, comprenant une partie déformée plastiquement de sorte que la deuxième région (402) possède l'inclinaison par rapport à la première région (401).

6. Afficheur (400) de l'une quelconque des revendications 1 à 5,
lorsque le deuxième sous-pixel (420) est vu dans une direction opposée à une direction (l2) dans laquelle le deuxième sous-pixel (420) est orienté, l'une (451) des deuxièmes parties de blocage (450) chevauchant une partie du deuxième sous-pixel (420), l'autre (452) des deuxièmes parties de blocage (450) étant espacée du deuxième sous-pixel (420), et
une distance entre l'axe de pliage (f) et l'une (451) des deuxièmes parties de blocage (450) étant plus courte qu'une distance entre l'axe de pliage (f) et l'autre (452) des deuxièmes parties de blocage (450).

7. Afficheur (400) de l'une quelconque des revendications 1 à 6,
une largeur (w4) de chacune des deuxièmes parties de blocage (450) étant inférieure à une largeur (w2) de chacune des premières parties de blocage (440).

8. Afficheur (400) de l'une quelconque des revendications 1 à 7,
ladite couche de pixels (405) comprenant en outre :
des premières parties de définition de pixel (471) qui entourent chacune le premier sous-pixel (410) ; et
des secondes parties de définition de pixel (472) qui entourent chacune le deuxième sous-pixel (420),
lorsque les premières parties de blocage (440) sont vues dans une direction opposée à une direction (l1) dans laquelle le premier sous-pixel (410) est orienté, chacune des premières parties de blocage (440) étant espacée des deux extrémités (471a, 471b) de chacune des premières parties de définition de pixel (471), et
lorsque les deuxièmes parties de blocage (450) sont vues dans une direction opposée à la direction (l2) dans laquelle le deuxième sous-pixel (420) est orienté, chacune des deuxièmes parties de blocage (450) chevauchant une extrémité (472a) de chacune des secondes parties de définition de pixel (472) qui est la plus éloignée de l'axe de pliage (f) parmi les deux extrémités (472a, 472b) de chacune des secondes parties de définition de pixel (472).

9. Afficheur (400) de l'une quelconque des revendications 1 à 8,
une distance entre les deuxièmes parties de blocage (450) étant différente d'une distance entre les premières parties de blocage (440).

10. Afficheur (400) de l'une quelconque des revendications 1 à 9, comprenant en outre une couche d'encapsulation (407), disposée entre la couche de pixels (405) et la couche de blocage de lumière (406), encapsulant le premier sous-pixel (410) et le deuxième sous-pixel (420),
une épaisseur d'une partie de la couche d'encapsulation (407) disposée dans la première région (401) étant égale ou inférieure à une épaisseur d'une autre partie de la couche d'encapsulation (407) disposée dans la deuxième région (402).

11. Afficheur (400) de l'une quelconque des revendications 1 à 10,
ladite couche de blocage de lumière (406) comprenant :
un premier élément filtre coloré (481) disposé entre les premières parties de blocage (440) ; et
un second élément filtre coloré (482) disposé entre les deuxièmes parties de blocage (450),
une largeur du second élément filtre coloré (482) étant supérieure à une largeur du premier élément filtre coloré (481).

12. Afficheur (400) de l'une quelconque des revendications 1 à 11, comprenant en outre :
une troisième région (403), raccordée à la deuxième région (402), disposée le long de l'axe de pliage (f) de l'afficheur (400) de façon à posséder une inclinaison par rapport à la première région (401) et à la deuxième région (402),
ladite couche de pixels (405) comprenant en outre un troisième sous-pixel (430) disposé à l'intérieur de la troisième région (403),
ladite couche de blocage de lumière (406) comprenant en outre des troisièmes parties de blocage (460), disposées au-dessus du troisième sous-pixel (430), espacées les unes des autres, et
une zone du troisième sous-pixel (430) couverte par l'une (461) des troisièmes parties de blocage (460) étant différente d'une zone du troisième sous-pixel (430) couverte par une autre (462) des troisièmes parties de blocage (460).

13. Afficheur (400) de l'une quelconque des revendications 1 à 12,
lorsque le troisième sous-pixel (430) est vu dans une direction opposée à une direction (l3) dans laquelle le troisième sous-pixel (430) est orienté, l'une (461) des troisièmes parties de blocage (460) chevauchant une partie du troisième sous-pixel (430), l'autre (462) des troisièmes parties de blocage (460) étant espacée du troisième sous-pixel (430), et
une distance entre l'axe de pliage (f) et l'une (461) des troisièmes parties de blocage (460) étant plus courte qu'une distance entre l'axe de pliage (f) et l'autre (462) des troisièmes parties de blocage (460).

14. Afficheur (400) de l'une quelconque des revendications 1 à 13,
une taille du deuxième sous-pixel (420) étant plus grande qu'une taille du premier sous-pixel (410).

15. Dispositif électronique comprenant l'afficheur (400) de l'une quelconque des revendications 1 à 14.
